(19) Europäisches Patentamt
European Patent Office
Office européen des brevets

(11) **EP 4 507 255 A1**

(12) **EUROPEAN PATENT APPLICATION**
published in accordance with Art. 153(4) EPC

(43) Date of publication:
**12.02.2025 Bulletin 2025/07**

(21) Application number: **23795456.5**

(22) Date of filing: **26.04.2023**

(51) International Patent Classification (IPC):
**H04L 27/144** (2006.01)

(52) Cooperative Patent Classification (CPC):
**H04L 27/144**

(86) International application number:
**PCT/CN2023/090781**

(87) International publication number:
**WO 2023/208024 (02.11.2023 Gazette 2023/44)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **29.04.2022 CN 202210474157
08.07.2022 CN 202210800941**

(71) Applicant: **Huawei Technologies Co., Ltd.
Shenzhen, Guangdong 518129 (CN)**

(72) Inventor: **LI, Qiang
Shenzhen, Guangdong 518129 (CN)**

(74) Representative: **Grünecker Patent- und
Rechtsanwälte
PartG mbB
Leopoldstraße 4
80802 München (DE)**

(54) **COMMUNICATION APPARATUS AND COMMUNICATION METHOD**

(57) Embodiments of this application provide a communication apparatus and a communication method. The communication apparatus is configured to receive a first signal and a second signal from a same device, and the second signal indicates the communication apparatus to enter a connected state. The communication apparatus includes a first branch and a second branch. The first branch includes a first frequency-amplitude converter, configured to obtain first amplitude information of a third signal, where the third signal is a signal obtained by performing frequency mixing on the first signal and a first local oscillator signal. The second branch is configured to demodulate a fourth signal, where the fourth signal is a signal obtained by performing frequency mixing on the second signal and a second local oscillator signal, the second local oscillator signal is a signal obtained by performing frequency offset correction on the first local oscillator signal based on the first amplitude information, the second branch includes a second frequency-amplitude converter, and a linear working interval of the second frequency-amplitude converter is smaller than a linear working interval of the first frequency-amplitude converter. In this way, signal demodulation performance of the communication apparatus can be improved.

Communication apparatus 800

First branch 810 — First frequency-amplitude converter 811

Second branch 820 — Second frequency-amplitude converter 821

FIG. 8

Processed by Luminess, 75001 PARIS (FR)

**Description**

This application claims priority to Chinese Patent Application No. 202210474157.2, filed with the China National Intellectual Property Administration on April 29, 2022 and entitled "RECEIVER", which is incorporated herein by reference in its entirety.

This application claims priority to Chinese Patent Application No. 202210800941.8, filed with the China National Intellectual Property Administration on July 8, 2022 and entitled "COMMUNICATION APPARATUS AND COMMUNICATION METHOD", which is incorporated herein by reference in its entirety.

**TECHNICAL FIELD**

Embodiments of this application relate to the field of communication technologies, and more specifically, to a communication apparatus and a communication method.

**BACKGROUND**

In a wireless communication system, a signal is radiated to space through an antenna in a form of an electromagnetic wave. Generally, before transmitting a signal, a sending device performs modulation processing on the signal, and up-converts a spectrum of a baseband signal to a high carrier frequency, so that the communication system can work on an allocated channel. For a receiving device, the receiving device needs to perform down-conversion and demodulation processing on the signal sent by the sending device, to obtain information transmitted by the sending device. Demodulation is an inverse process of modulation, and demodulation schemes vary with modulation schemes. For example, if information on a signal is modulated on a carrier frequency in a frequency shift keying (frequency shift keying, FSK) modulation scheme, the receiving device needs to obtain the sent information at a frequency of the received signal in a demodulation process.

The baseband signal sent by the sending device side uses a radio frequency after being up-converted. Therefore, before demodulating the received signal, the receiving device first needs to perform frequency reduction processing on the received signal. Generally, the receiving device may perform frequency mixing on the received signal and a local oscillator signal generated by the receiving device, to complete down-conversion processing on the received signal. However, due to stability of an oscillator of the receiving device, an ambient environment, and other factors, an offset usually exists between an ideal frequency and a frequency of the local oscillator signal generated by the receiving device. In this case, an error exists in a baseband signal obtained by demodulating the received signal by the receiving device. Consequently, demodulation performance of the receiving device is severely affected.

**SUMMARY**

Embodiments of this application provide a communication apparatus and a communication method. The communication apparatus may perform frequency offset correction on a local oscillator signal generated by the communication apparatus. In this way, an error of a baseband signal obtained by demodulating a received signal by the communication apparatus can be reduced, thereby improving demodulation performance of a receiving device.

According to a first aspect, a communication apparatus is provided. The communication apparatus is configured to receive a first signal and a second signal, where both the second signal and the first signal are from a same device, and the second signal indicates the communication apparatus to enter a connected state. The communication apparatus includes a first branch and a second branch. The first branch includes a first frequency-amplitude converter, configured to obtain first amplitude information of a third signal, where the third signal is a signal obtained by performing frequency mixing on the first signal and a first local oscillator signal, and the first local oscillator signal is a local oscillator signal generated by the communication apparatus. The second branch is configured to demodulate a fourth signal, where the fourth signal is a signal obtained by performing frequency mixing on the second signal and a second local oscillator signal, the second local oscillator signal is a signal obtained by performing frequency offset correction on the first local oscillator signal based on the first amplitude information, the second branch includes a second frequency-amplitude converter, and a linear working interval corresponding to the second frequency-amplitude converter is smaller than a linear working interval corresponding to the first frequency-amplitude converter.

In this technical solution, the communication apparatus first obtains, by using the first frequency-amplitude converter on the first branch, the first amplitude information of the third signal obtained by performing frequency mixing on the first signal and a first local oscillator signal. Then, the communication apparatus demodulates, through the second branch, the fourth signal obtained by performing frequency mixing on a second local oscillator signal and the second signal, where the second local oscillator signal is the signal obtained by performing frequency offset correction on the first local oscillator signal based on the first amplitude information. Because the first local oscillator signal has a frequency offset, the linear working interval corresponding to the first frequency-amplitude converter on the first branch is set to be larger than the linear working interval corresponding to the second frequency-amplitude converter, so that a frequency of the third signal obtained by performing frequency mixing on the first signal and a first local oscillator signal does not exceed the linear working interval corresponding to the first frequency-amplitude converter. Therefore, the first frequency-amplitude converter can accurately obtain the first amplitude information of the third signal, to subsequently perform accurate frequency offset correction on the first local oscillator signal based on the first amplitude information.

Further, the communication apparatus demodulates, through the second branch, the fourth signal obtained by performing frequency mixing on a second local oscillator signal and the second signal. Because the second local oscillator signal is the signal obtained by performing frequency offset correction on the first local oscillator signal, a frequency offset value of the fourth signal is less than a frequency offset value of a signal obtained by performing frequency mixing on the first local oscillator signal and the second signal. In this way, when the linear working interval corresponding to the second frequency-amplitude converter on the second branch is set to be smaller than the linear working interval of the first frequency-amplitude converter, the fourth signal can still be accurately demodulated. Therefore, demodulation performance of the communication apparatus is not severely affected.

With reference to the first aspect, in some implementations of the first aspect, the communication apparatus further includes a frequency offset estimation module and a local oscillator. The first frequency-amplitude converter is further configured to send the first amplitude information to the frequency offset estimation module. The frequency offset estimation module is configured to: obtain a first frequency offset value based on the first amplitude information, and send the first frequency offset value to the local oscillator. The local oscillator is configured to perform frequency offset correction on the first local oscillator signal based on the first frequency offset value, to obtain the second local oscillator signal.

With reference to the first aspect, in some implementations of the first aspect, the first frequency-amplitude converter includes a first phase shifting unit, and the first phase shifting unit introduces different phase shifts to signals at different frequencies based on a first frequency-phase curve. The second frequency-amplitude converter includes a second phase shifting unit, the second phase shifting unit introduces different phase shifts to signals at different frequencies based on a second frequency-phase curve, and a slope of the second frequency-phase curve is greater than a slope of the first frequency-phase curve.

With reference to the first aspect, in some implementations of the first aspect, a differential frequency modulation scheme is used for the second signal. The second frequency-amplitude converter is configured to obtain third amplitude information of the fourth signal. The second branch is further specifically configured to: obtain, based on the third amplitude information of the fourth signal, a frequency difference of the fourth signal transmitted in adjacent time units, where a frequency of the fourth signal transmitted in an $i^{th}$ time unit is: $f(i)=mod[f(i-1)+\Delta f_1(i), B1]$, $\Delta f_1(i)$ is a difference between a frequency of an $i^{th}$ fourth signal and a frequency of an $(i-1)^{th}$ fourth signal in a sequence of the fourth signal, B 1 is a preset first bandwidth value, and $i$ is an integer greater than 1; and obtain, based on the frequency difference of the fourth signal, modulation information carried in the fourth signal.

Because a time interval between two consecutive time units is extremely short, even if a residual frequency offset exists in the local oscillator signal generated by the communication apparatus, residual frequency offsets of local oscillator signals generated in the two consecutive time units by the communication apparatus may be considered to be the same. In this way, the residual frequency offset of the local oscillator signal generated by the communication apparatus may be canceled by subtracting between frequencies of the fourth signals in the two consecutive time units (that is, a differential frequency modulation scheme). Therefore, the demodulation performance of the communication apparatus is not further affected.

With reference to the first aspect, in some implementations of the first aspect, a differential frequency modulation scheme is used for the first signal, and the first branch is configured to: obtain, based on the first amplitude information, a frequency difference of the third signal transmitted in adjacent time units, where a frequency of the third signal transmitted in a $j^{th}$ time unit is: $f(i)=mod[f(j-1)+\Delta f_1(j), B3]$, $\Delta f_1(j)$ is a difference between a frequency of a $j^{th}$ third signal and a frequency of a $(j-1)^{th}$ third signal in a sequence of the third signal, B3 is a preset third bandwidth value, and $j$ is an integer greater than 1; and obtain, based on the frequency difference of the third signal, modulation information carried in the third signal.

Because a time interval between two consecutive time units is extremely short, even if the residual frequency offset exists in the local oscillator signal generated by the communication apparatus, residual frequency offsets of local oscillator signals generated in the two consecutive time units by the communication apparatus may be considered to be the same. In this way, the residual frequency offset of the local oscillator signal generated by the communication apparatus may be canceled by subtracting between frequencies of the third signals in the two consecutive time units (that is, a differential frequency modulation scheme). Therefore, the demodulation performance of the communication apparatus is not further affected.

With reference to the first aspect, in some implementations of the first aspect, the communication apparatus is further configured to receive first data and second data.

In an implementation, the first data and the first signal are sent in an FDM manner, and/or the second data and the second signal are sent in an FDM manner, where a frequency guard interval between the first signal and the first data is greater than a frequency guard interval between the second signal and the second data.

The first signal is used to perform frequency offset correction on the first local oscillator signal, and the second signal indicates the communication apparatus to enter the connected state. Therefore, the communication apparatus first performs frequency offset correction on the first local oscillator signal based on the first signal, and then demodulates the received second signal based on the second local oscillator signal obtained by performing frequency offset correction on the first local oscillator signal. Because a frequency offset exists in a process in which the communication apparatus performs frequency offset correction on the first local oscillator signal, the frequency guard interval between the first signal and the first data is set to be larger (relative to the frequency guard interval between the second signal and the second data), so that first data normally transmitted on an adjacent frequency band cannot enter the first branch. In a process in which the received second signal is demodulated based on the second local oscillator signal obtained by performing frequency offset correction on the first local oscillator signal, because the frequency offset correction has been performed on the first local oscillator signal, a frequency offset value of the second local oscillator signal is less than a frequency offset value of the first local oscillator signal. Therefore, the frequency guard interval between the second signal and the second data is set to be smaller (relative to the frequency guard interval between the first signal and the first data), so that second data normally transmitted on an adjacent frequency band cannot enter the second branch. In addition, the smaller guard interval helps improve system resource utilization.

With reference to the first aspect, in some implementations of the first aspect, the communication apparatus is further configured to obtain configuration information, where the configuration information indicates at least one of the following: a sending periodicity of the first signal, a bit sequence of the first signal, the frequency guard interval between the first signal and the first data, and the frequency guard interval between the second signal and the second data.

With reference to the first aspect, in some implementations of the first aspect, a modulation order of the first signal is less than a modulation order of the second signal, the first signal is a single-frequency signal, or a modulation order of the first signal is 2.

A lower modulation order indicates less information carried in each symbol (symbol) of a signal and a smaller quantity of amplitudes converted from frequencies by the communication apparatus. In this way, in a same interval, a smaller quantity of amplitudes indicates a larger distance between amplitudes. Therefore, the communication apparatus has better demodulation performance for the first signal.

With reference to the first aspect, in some implementations of the first aspect, a transmit power of the first signal is greater than a transmit power of the second signal.

The transmit power of the first signal is greater than the transmit power of the second signal. In this way, the communication apparatus can obtain a first signal with strong signal strength, so that better demodulation performance can be obtained for the first signal.

According to a second aspect, a communication apparatus is provided. The communication apparatus is configured to receive a second signal, where the second signal indicates the communication apparatus to enter a connected state. The communication apparatus includes a first branch and a second branch. The first branch includes a first frequency-amplitude converter, configured to obtain second amplitude information of a fifth signal, where the fifth signal is a signal obtained by performing frequency mixing on the second signal and a first local oscillator signal, and the first local oscillator signal is a local oscillator signal generated by the communication apparatus. The second branch is configured to demodulate a sixth signal, where the sixth signal is a signal obtained by performing frequency mixing on the second signal and a second local oscillator signal, the second local oscillator signal is a signal obtained by performing frequency offset correction on the first local oscillator signal based on the second amplitude information, the second branch includes a second frequency-amplitude converter, and a linear working interval corresponding to the second frequency-amplitude converter is smaller than a linear working interval corresponding to the first frequency-amplitude converter.

In this technical solution, the communication apparatus first obtains, by using the first frequency-amplitude converter on the first branch, the second amplitude information of the fifth signal obtained by performing frequency mixing on the second signal and a first local oscillator signal. Then, the communication apparatus demodulates, through the second branch, the sixth signal obtained by performing frequency mixing on a second local oscillator signal and the second signal, where the second local oscillator signal is the signal obtained by performing frequency offset correction on the first local oscillator signal based on the second amplitude information. Because the first local oscillator signal has a frequency offset, the linear working interval corresponding to the first frequency-amplitude converter on the first branch is set to be larger than the linear working interval corresponding to the second frequency-amplitude converter, so that a frequency of the fifth signal obtained by performing frequency mixing on the first signal and a first local oscillator signal does not exceed the linear working interval corresponding to the first frequency-amplitude converter. Therefore, the first frequency-amplitude converter can accurately obtain the second amplitude information of the fifth signal, to subsequently perform accurate frequency offset correction on the first local oscillator signal based on the second amplitude information.

Further, the communication apparatus demodulates, through the second branch, the sixth signal obtained by performing frequency mixing on a second local oscillator signal and the second signal. Because the second local oscillator signal is the signal obtained by performing frequency offset correction on the first local oscillator signal, a frequency offset value of the sixth signal is less than a frequency offset value of the signal obtained by performing frequency mixing on a first local oscillator signal and the second signal. In this way, when the linear working interval corresponding to the second frequency-amplitude converter on the second branch is set to be smaller than the linear working interval of the first frequency-amplitude converter, the sixth signal can still be accurately demodulated. Therefore, demodulation performance of the communication apparatus is not severely affected.

With reference to the second aspect, in some implementations of the second aspect, the communication apparatus further includes a frequency offset estimation module and a local oscillator. The first frequency-amplitude converter is further configured to send the second amplitude information to the frequency offset estimation module. The frequency offset estimation module is configured to: obtain a second frequency offset value based on the second amplitude information, and send the second frequency offset value to the local oscillator. The local oscillator is configured to perform frequency offset correction on the first local oscillator signal based on the second frequency offset value, to obtain the second local oscillator signal.

With reference to the second aspect, in some implementations of the second aspect, the first frequency-amplitude converter includes a first phase shifting unit, and the first phase shifting unit introduces different phase shifts to signals at different frequencies based on a first frequency-phase curve. The second frequency-amplitude converter includes a second phase shifting unit, the second phase shifting unit introduces different phase shifts to signals at different frequencies based on a second frequency-phase curve, and a slope of the second frequency-phase curve is greater than a slope of the first frequency-phase curve.

With reference to the second aspect, in some implementations of the second aspect, a differential frequency modulation scheme is used for the second signal, and the second branch is further specifically configured to: obtain a frequency difference of a filtered sixth signal transmitted in adjacent time units, where a frequency of the filtered sixth signal transmitted in an $i^{th}$ time unit is: $f(i)=\mathrm{mod}[f(i\text{-}1)+\varDelta f_2(i), \text{B2}]$, $\varDelta f_2(i)$ is a difference between a frequency of an $i^{th}$ sixth signal and a frequency of an $(i\text{-}1)^{th}$ sixth signal in a sequence of the filtered sixth signal, B2 is a preset second bandwidth value, and $i$ is an integer greater than 1; and obtain, based on the frequency difference of the filtered sixth signal, modulation information carried in the filtered sixth signal.

Because a time interval between two consecutive time units is extremely short, even if a residual frequency offset exists in the local oscillator signal generated by the communication apparatus, residual frequency offsets of local oscillator signals generated in the two consecutive time units by the communication apparatus may be considered to be the same. In this way, the residual frequency offset of the local oscillator signal generated by the communication apparatus may be canceled by subtracting between frequencies of the sixth signals in the two consecutive time units (that is, a differential frequency modulation scheme). Therefore, the demodulation performance of the communication apparatus is not further affected.

According to a third aspect, a communication apparatus is provided. The communication apparatus is configured to receive a first signal and a second signal, where both the second signal and the first signal are from a same device, and the second signal indicates the communication apparatus to enter a connected state. The communication apparatus includes a first branch and a second branch. The first branch includes a first filter, configured to filter a third signal, where the third signal is a signal obtained by performing frequency mixing on the first signal and a first local oscillator signal, and the first local oscillator signal is a local oscillator signal generated by the communication apparatus. The second branch includes a second filter, configured to filter a fourth signal, where the fourth signal is a signal obtained by performing frequency mixing on the second signal and a second local oscillator signal, the second local oscillator signal is a signal obtained by performing frequency offset correction on the first local oscillator signal based on first amplitude information of the third signal, and a bandwidth of the second filter is less than a bandwidth of the first filter.

In this technical solution, the communication apparatus first filters, by using the first filter on the first branch, the third signal obtained by performing frequency mixing on the first signal and a first local oscillator signal. Then, the communication apparatus filters, by using the second filter on the second branch, the fourth signal obtained by performing frequency mixing on the second signal and a second local oscillator signal, where the second local oscillator signal is a signal obtained by performing frequency offset correction on the first local oscillator signal based on the first amplitude information of the third signal. Because the first local oscillator signal has a frequency offset, the bandwidth of the first filter on the first branch is set to be greater than the bandwidth of the second filter, so that the first filter still does not filter out the third signal even if the first local oscillator signal has the frequency offset. In this way, the frequency offset correction may be performed subsequently on the first local oscillator signal based on the third signal.

Further, the communication apparatus filters, by using the second filter on the second branch, the fourth signal obtained by performing frequency mixing on the second signal and a second local oscillator signal. Because the second local oscillator signal is the signal obtained by performing frequency offset correction on the first local oscillator signal, a frequency offset value of the fourth signal is less than a frequency offset value of a signal obtained by performing frequency mixing on the first local oscillator signal and the second signal. In this way, the bandwidth of the second filter on the second branch is set to a small bandwidth (relative to the bandwidth of the first filter), to ensure that the second filter does not filter out the fourth signal even if a residual frequency offset exists, and the second filter can filter out out-of-band noise because a passband is narrow. This reduces a noise level of the communication apparatus, to improve performance of demodulating the fourth signal by the communication apparatus.

With reference to the third aspect, in some implementations of the third aspect, the first branch further includes a first frequency-amplitude converter, configured to obtain the first amplitude information. The communication apparatus further includes a frequency offset estimation module and a local oscillator. The first frequency-amplitude converter is further configured to send the first amplitude information to the frequency offset estimation module. The frequency offset estimation module is configured to: obtain a first frequency offset value based on the first amplitude information, and send the first frequency offset value to the local oscillator. The local oscillator is configured to perform frequency offset correction on the first local oscillator signal based on the first frequency offset value, to obtain the second local oscillator signal.

With reference to the third aspect, in some implementations of the third aspect, the second branch further includes a second frequency-amplitude converter, configured to demodulate a filtered fourth signal, where a linear working interval corresponding to the second frequency-amplitude converter is smaller than a linear working interval corresponding to the first frequency-amplitude converter.

With reference to the third aspect, in some implementations of the third aspect, the first frequency-amplitude converter includes a first phase shifting unit, and the first phase shifting unit introduces different phase shifts to signals at different frequencies based on a first frequency-phase curve. The second frequency-amplitude converter includes a second phase shifting unit, the second phase shifting unit introduces different phase shifts to signals at different frequencies based on a second frequency-phase curve, and a slope of the second frequency-phase curve is greater than a slope of the first frequency-phase curve.

With reference to the third aspect, in some implementations of the third aspect, a differential frequency modulation scheme is used for the second signal. The second frequency-amplitude converter is configured to obtain third amplitude information of the fourth signal. The second branch is further specifically configured to: obtain, based on the third amplitude information of the fourth signal, a frequency difference of the fourth signal transmitted in adjacent time units, where a frequency of the fourth signal transmitted in an $i^{th}$ time unit is: $f(i)=mod[f(i-1)+\Delta f_1(i), B1]$, $\Delta f_1(i)$ is a difference between a frequency of an $i^{th}$ fourth signal and a frequency of an $(i-1)^{th}$ fourth signal in a sequence of the fourth signal, B 1 is a preset first bandwidth value, and $i$ is an integer greater than 1; and obtain, based on the frequency difference of the filtered fourth signal, modulation information carried in the filtered fourth signal.

With reference to the third aspect, in some implementations of the third aspect, a differential frequency modulation scheme is used for the first signal, and the first branch is configured to: obtain, based on the first amplitude information, a frequency difference of the third signal transmitted in adjacent time units, where a frequency of the third signal transmitted in a $j^{th}$ time unit is: $f(i)=mod[f(j-1)+\Delta f_1(j), B3]$, $\Delta f_1(j)$ is a difference between a frequency of a $j^{th}$ third signal and a frequency of a $(j-1)^{th}$ third signal in a sequence of the third signal, B3 is a preset third bandwidth value, and $j$ is an integer greater than 1; and obtain, based on the frequency difference of the third signal, modulation information carried in the third signal.

For technical effects of any possible implementation of the third aspect, refer to technical effects of a corresponding implementation of the first aspect. Details are not described herein again.

According to a fourth aspect, a communication apparatus is provided. The communication apparatus is configured to receive a second signal, where the second signal indicates the communication apparatus to enter a connected state. The communication apparatus includes a first branch and a second branch. The first branch includes a first filter, configured to filter a fifth signal, where the fifth signal is a signal obtained by performing frequency mixing on the second signal and a first local oscillator signal, and the first local oscillator signal is a local oscillator signal generated by the communication apparatus. The second branch includes a second filter, configured to filter a sixth signal, where the sixth signal is a signal obtained by performing frequency mixing on the second signal and a second local oscillator signal, the second local oscillator signal is a signal obtained by performing frequency offset correction on the first local oscillator signal based on second amplitude information of the fifth signal, and a bandwidth of the second filter is less than a bandwidth of the first filter.

In this technical solution, the communication apparatus first filters, by using the first filter on the first branch, the fifth signal obtained by performing frequency mixing on the second signal and a first local oscillator signal. Then, the communication apparatus filters, by using the second filter on the second branch, the sixth signal obtained by performing frequency mixing on the second signal and a second local oscillator signal, where the second local oscillator signal is a signal obtained by performing frequency offset correction on the first local oscillator signal based on the second amplitude information of the fifth signal. Because the first local oscillator signal has a frequency offset, the bandwidth of the first filter on the first branch is set to be greater than the bandwidth of the second filter, so that the first filter still does not filter out the fifth signal even if the first local oscillator signal has the frequency offset. In this way, the frequency offset correction may be performed subsequently on the first local oscillator signal based on the fifth signal.

Further, the communication apparatus filters, by using the second filter on the second branch, the sixth signal obtained by performing frequency mixing on the second signal and a second local oscillator signal. Because the second local oscillator signal is the signal obtained by performing frequency offset correction on the first local oscillator signal, a frequency offset value of the sixth signal is less than a frequency offset value of the signal obtained by performing frequency mixing on a first local oscillator signal and the second signal. In this way, the bandwidth of the second filter on the second branch is set to a small bandwidth (relative to the bandwidth of the first filter), to ensure that the second filter does not filter out the sixth signal even if a residual frequency offset exists, and the second filter can filter out out-of-band noise because a passband is narrow. This reduces a noise level of the communication apparatus, to improve performance of demodulating the sixth signal by the communication apparatus.

With reference to the fourth aspect, in some implementations of the fourth aspect, the first branch further includes a first frequency-amplitude converter, configured to obtain the second amplitude information. The communication apparatus further includes a frequency offset estimation module and a local oscillator. The first frequency-amplitude converter is further configured to send the second amplitude information to the frequency offset estimation module. The frequency offset estimation module is configured to: obtain a second frequency offset value based on the second amplitude information, and send the second frequency offset value to the local oscillator. The local oscillator is configured to perform frequency offset correction on the first local oscillator signal based on the second frequency offset value, to obtain the second local oscillator signal.

With reference to the fourth aspect, in some implementations of the fourth aspect, the second branch further includes a second frequency-amplitude converter, configured to demodulate a filtered sixth signal, where a linear working interval corresponding to the second frequency-amplitude converter is smaller than a linear working interval corresponding to the first frequency-amplitude converter.

With reference to the fourth aspect, in some implementations of the fourth aspect, the first frequency-amplitude converter includes a first phase shifting unit, and the first phase shifting unit introduces different phase shifts to signals at different frequencies based on a first frequency-phase curve. The second frequency-amplitude converter includes a second phase shifting unit, the second phase shifting unit introduces different phase shifts to signals at different frequencies based on a second frequency-phase curve, and a slope of the second frequency-phase curve is greater than a slope of the first frequency-phase curve.

With reference to the fourth aspect, in some implementations of the fourth aspect, a differential frequency modulation scheme is used for the second signal, and the second branch is further specifically configured to: obtain a frequency difference of the filtered sixth signal transmitted in adjacent time units, where a frequency of the filtered sixth signal transmitted in an $i$th time unit is: $f(i)=\text{mod}[f(i-1)+\Delta f_2(i), \text{B2}]$, $\Delta f_2(i)$ is a difference between a frequency of an $i$th sixth signal and a frequency of an $(i-1)$th sixth signal in a sequence of the filtered sixth signal, B2 is a preset second bandwidth value, and $i$ is an integer greater than 1; and obtain, based on the frequency difference of the filtered sixth signal, modulation information carried in the filtered sixth signal.

For technical effects of any possible implementation of the fourth aspect, refer to technical effects of a corresponding implementation of the second aspect. Details are not described herein again.

For example, in an implementation, the communication apparatus in any implementation of the first aspect to the fourth aspect may be an access network device or a chip or a circuit in an access network device. In another implementation, the communication apparatus in any implementation of the first aspect to the fourth aspect may be a terminal device or a chip or a circuit in a terminal device.

According to a fifth aspect, a communication method is provided. The communication method is applied to a communication apparatus, the communication apparatus includes a first branch and a second branch, the first branch includes a first frequency-amplitude converter, the second branch includes a second frequency-amplitude converter, a linear working interval corresponding to the second frequency-amplitude converter is smaller than a linear working interval corresponding to the first frequency-amplitude converter, and the communication method includes: receiving a first signal and a second signal, where both the second signal and the first signal are from a same device, and the second signal indicates the communication apparatus to enter a connected state; obtaining first amplitude information of a third signal by using the first frequency-amplitude converter, where the third signal is a signal obtained by performing frequency mixing on the first signal and a first local oscillator signal, and the first local oscillator signal is a local oscillator signal generated by the communication apparatus; and demodulating a fourth signal through the second branch, where the fourth signal is a signal obtained by performing frequency mixing on the second signal and a second local oscillator signal, and the second local oscillator signal is a signal obtained by performing frequency offset correction on the first local oscillator signal based on the first amplitude information.

With reference to the fifth aspect, in some implementations of the fifth aspect, before the demodulating a fourth signal through the second branch, the communication method further includes: obtaining a first frequency offset value based on the first amplitude information; and performing frequency offset correction on the first local oscillator signal based on the first frequency offset value, to obtain the second local oscillator signal.

With reference to the fifth aspect, in some implementations of the fifth aspect, the first frequency-amplitude converter includes a first phase shifting unit, and the first phase shifting unit introduces different phase shifts to signals at different frequencies based on a first frequency-phase curve. The second frequency-amplitude converter includes a second phase shifting unit, the second phase shifting unit introduces different phase shifts to signals at different frequencies based on a second frequency-phase curve, and a slope of the second frequency-phase curve is greater than a slope of the first frequency-phase curve.

With reference to the fifth aspect, in some implementations of the fifth aspect, a differential frequency modulation scheme is used for the second signal, and the communication method further includes: obtaining third amplitude information of the fourth signal by using the second frequency-amplitude converter; and the demodulating a fourth signal through the second branch includes: obtaining, through the second branch, a frequency difference of the fourth signal transmitted in adjacent time units, where a frequency of the fourth signal transmitted in an $i$th time unit is: $f(i)=\text{mod}[f(i\text{-}1)+\Delta f_1(i), \text{B1}]$, $\Delta f_1(i)$ is a difference between a frequency of an $i$th fourth signal and a frequency of an $(i\text{-}1)$th fourth signal in a sequence of the fourth signal, B1 is a preset first bandwidth value, and $i$ is an integer greater than 1; and obtaining, based on the frequency difference of the fourth signal, modulation information carried in the fourth signal.

With reference to the fifth aspect, in some implementations of the fifth aspect, a differential frequency modulation scheme is used for the first signal, and the method further includes: obtaining, through the first branch based on the first amplitude information, a frequency difference of the third signal transmitted in adjacent time units, where a frequency of the third signal transmitted in a $j$th time unit is: $f(i)=\text{mod}[f(j\text{-}1)+\Delta f_1(j), \text{B3}]$, $\Delta f_1(j)$ is a difference between a frequency of a $j$th third signal and a frequency of a $(j\text{-}1)$th third signal in a sequence of the third signal, B3 is a preset third bandwidth value, and $j$ is an integer greater than 1; and obtaining, based on the frequency difference of the third signal, modulation information carried in the third signal.

For technical effects of any possible implementation of the fifth aspect, refer to technical effects of a corresponding implementation of the first aspect. Details are not described herein again.

According to a sixth aspect, a communication method is provided. The communication method is applied to a communication apparatus, the communication apparatus includes a first branch and a second branch, the first branch includes a first frequency-amplitude converter, the second branch includes a second frequency-amplitude converter, a linear working interval corresponding to the second frequency-amplitude converter is smaller than a linear working interval corresponding to the first frequency-amplitude converter, and the communication method includes: receiving a second signal, where the second signal indicates the communication apparatus to enter a connected state; obtaining second amplitude information of a fifth signal by using the first frequency-amplitude converter, where the fifth signal is a signal obtained by performing frequency mixing on the second signal and a first local oscillator signal, and the first local oscillator signal is a local oscillator signal generated by the communication apparatus; and demodulating a sixth signal through the second branch, where the sixth signal is a signal obtained by performing frequency mixing on the second signal and a second local oscillator signal, and the second local oscillator signal is a signal obtained by performing frequency offset correction on the first local oscillator signal based on the second amplitude information.

With reference to the sixth aspect, in some implementations of the sixth aspect, before the demodulating a sixth signal through the second branch, the communication method further includes: obtaining a second frequency offset value based on the second amplitude information; and performing frequency offset correction on the first local oscillator signal based on the second frequency offset value, to obtain the second local oscillator signal.

With reference to the sixth aspect, in some implementations of the sixth aspect, the first frequency-amplitude converter includes a first phase shifting unit, and the first phase shifting unit introduces different phase shifts to signals at different frequencies based on a first frequency-phase curve. The second frequency-amplitude converter includes a second phase shifting unit, the second phase shifting unit introduces different phase shifts to signals at different frequencies based on a second frequency-phase curve, and a slope of the second frequency-phase curve is greater than a slope of the first frequency-phase curve.

With reference to the sixth aspect, in some implementations of the sixth aspect, a differential frequency modulation scheme is used for the second signal, and the demodulating a sixth signal through the second branch includes: obtaining, through the second branch, a frequency difference of a filtered sixth signal transmitted in adjacent time units, where a frequency of the filtered sixth signal transmitted in an $i$th time unit is: $f(i)=\text{mod}[f(i\text{-}1)+\Delta f_2(i), \text{B2}]$, $\Delta f_2(i)$ is a difference between a frequency of an $i$th sixth signal and a frequency of an $(i\text{-}1)$th sixth signal in a sequence of the filtered sixth signal, B2 is a preset second bandwidth value, and $i$ is an integer greater than 1; and obtaining, based on the frequency difference of the filtered sixth signal, modulation information carried in the filtered sixth signal.

For technical effects of any possible implementation of the sixth aspect, refer to technical effects of a corresponding implementation of the second aspect. Details are not described herein again.

According to a seventh aspect, a communication method is provided. The communication method is applied to a communication apparatus, the communication apparatus includes a first branch and a second branch, the first branch includes a first filter, the second branch includes a second filter, a bandwidth of the second filter is less than a bandwidth of the first filter, and the communication method includes: receiving a first signal and a second signal, where both the second signal and the first signal are from a same device, and the second signal indicates the communication apparatus to enter a connected state; filtering a third signal by using the first filter, where the third signal is a signal obtained by performing frequency mixing on the first signal and a first local oscillator signal, and the first local oscillator signal is a local oscillator signal

signal generated by the communication apparatus; and filtering a fourth signal by using the second filter, where the fourth signal is a signal obtained by performing frequency mixing on the second signal and a second local oscillator signal, and the second local oscillator signal is a signal obtained by performing frequency offset correction on the first local oscillator signal based on first amplitude information of the third signal.

With reference to the seventh aspect, in some implementations of the seventh aspect, the first branch further includes a first frequency-amplitude converter, and before the filtering a fourth signal by using the second filter, the communication method further includes: obtaining the first amplitude information by using the first frequency-amplitude converter; obtaining a first frequency offset value based on the first amplitude information; and performing frequency offset correction on the first local oscillator signal based on the first frequency offset value, to obtain the second local oscillator signal.

With reference to the seventh aspect, in some implementations of the seventh aspect, the second branch further includes a second frequency-amplitude converter, a linear working interval corresponding to the second frequency-amplitude converter is smaller than a linear working interval corresponding to the first frequency-amplitude converter, and the communication method further includes: obtaining third amplitude information of the fourth signal by using the second frequency-amplitude converter; and demodulating a filtered fourth signal based on the third amplitude information of the fourth signal.

With reference to the seventh aspect, in some implementations of the seventh aspect, the first frequency-amplitude converter includes a first phase shifting unit, and the first phase shifting unit introduces different phase shifts to signals at different frequencies based on a first frequency-phase curve. The second frequency-amplitude converter includes a second phase shifting unit, the second phase shifting unit introduces different phase shifts to signals at different frequencies based on a second frequency-phase curve, and a slope of the second frequency-phase curve is greater than a slope of the first frequency-phase curve.

With reference to the seventh aspect, in some implementations of the seventh aspect, a differential frequency modulation scheme is used for the second signal, and the demodulating a filtered fourth signal based on the third amplitude information of the fourth signal includes: obtaining, through the second branch based on the third amplitude information of the fourth signal, a frequency difference of the fourth signal transmitted in adjacent time units, where a frequency of the fourth signal transmitted in an $i^{th}$ time unit is: $f(i)=mod[f(i-1)+\Delta f_1(i), B1]$, $\Delta f_1(i)$ is a difference between a frequency of an $i^{th}$ fourth signal and a frequency of an $(i-1)^{th}$ fourth signal in a sequence of the fourth signal, B1 is a preset first bandwidth value, and $i$ is an integer greater than 1; and obtaining, based on the frequency difference of the filtered fourth signal, modulation information carried in the filtered fourth signal.

With reference to the seventh aspect, in some implementations of the seventh aspect, a differential frequency modulation scheme is used for the first signal, and the method further includes: obtaining, through the first branch based on the first amplitude information, a frequency difference of the third signal transmitted in adjacent time units, where a frequency of the third signal transmitted in a $j^{th}$ time unit is: $f(i)=mod[f(j-1)+\Delta f_1(j), B3]$, $\Delta f_1(j)$ is a difference between a frequency of a $j^{th}$ third signal and a frequency of a $(j-1)^{th}$ third signal in a sequence of the third signal, B3 is a preset third bandwidth value, and $j$ is an integer greater than 1; and obtaining, based on the frequency difference of the third signal, modulation information carried in the third signal.

For technical effects of any possible implementation of the seventh aspect, refer to technical effects of a corresponding implementation of the third aspect. Details are not described herein again.

According to an eighth aspect, a communication method is provided. The communication method is applied to a communication apparatus, the communication apparatus includes a first branch and a second branch, the first branch includes a first filter, the second branch includes a second filter, a bandwidth of the second filter is less than a bandwidth of the first filter, and the communication method includes: receiving a second signal, where the second signal indicates the communication apparatus to enter a connected state; filtering a fifth signal by using the first filter, where the fifth signal is a signal obtained by performing frequency mixing on the second signal and a first local oscillator signal, and the first local oscillator signal is a local oscillator signal generated by the communication apparatus; and filtering a sixth signal by using the second filter, where the sixth signal is a signal obtained by performing frequency mixing on the second signal and a second local oscillator signal, and the second local oscillator signal is a signal obtained by performing frequency offset correction on the first local oscillator signal based on second amplitude information of the fifth signal.

With reference to the eighth aspect, in some implementations of the eighth aspect, the first branch further includes a first frequency-amplitude converter, and before the filtering a sixth signal by using the second filter, the communication method further includes: obtaining the second amplitude information by using the first frequency-amplitude converter; obtaining a second frequency offset value based on the second amplitude information; and performing frequency offset correction on the first local oscillator signal based on the second frequency offset value, to obtain the second local oscillator signal.

With reference to the eighth aspect, in some implementations of the eighth aspect, the second branch further includes a second frequency-amplitude converter, a linear working interval corresponding to the second frequency-amplitude converter is smaller than a linear working interval corresponding to the first frequency-amplitude converter, and the communication method further includes: demodulating a filtered sixth signal.

With reference to the eighth aspect, in some implementations of the eighth aspect, the first frequency-amplitude converter includes a first phase shifting unit, and the first phase shifting unit introduces different phase shifts to signals at different frequencies based on a first frequency-phase curve. The second frequency-amplitude converter includes a second phase shifting unit, the second phase shifting unit introduces different phase shifts to signals at different frequencies based on a second frequency-phase curve, and a slope of the second frequency-phase curve is greater than a slope of the first frequency-phase curve.

With reference to the eighth aspect, in some implementations of the eighth aspect, a differential frequency modulation scheme is used for the second signal, and the demodulating a filtered sixth signal includes: obtaining a frequency difference of the filtered sixth signal transmitted in adjacent time units, where a frequency of the filtered sixth signal transmitted in an $i^{th}$ time unit is: $f(i)=\mathrm{mod}[f(i-1)+\Delta f_2(i), B2]$, and $\Delta f_2(i)$ is a difference between a frequency of an $i^{th}$ sixth signal and a frequency of an $(i-1)^{th}$ sixth signal in a sequence of the filtered sixth signal, B2 is a preset second bandwidth value, and $i$ is an integer greater than 1; and obtaining, based on the frequency difference of the filtered sixth signal, modulation information carried in the filtered sixth signal.

For technical effects of any possible implementation of the eighth aspect, refer to technical effects of a corresponding implementation of the fourth aspect. Details are not described herein again.

For example, in an implementation, the communication method in any implementation of the fifth aspect to the eighth aspect may be performed by an access network device, or may be performed by a chip or a circuit used in an access network device. In another possible implementation, the communication method in any implementation of the fifth aspect to the eighth aspect may be performed by a terminal device, or may be performed by a chip or a circuit used in a terminal device.

According to a ninth aspect, a communication apparatus is provided, including one or more processors, a memory, and one or more computer programs. The one or more computer programs are stored in the memory. The one or more computer programs include instructions. When the instructions are executed by the communication apparatus, the communication apparatus is enabled to perform the communication method in any possible implementation of the fifth aspect to the eighth aspect.

According to a tenth aspect, a computer program product including instructions is provided. When the computer program product runs on a communication apparatus, the communication apparatus is enabled to perform the communication method in any possible implementation of the fifth aspect to the eighth aspect.

According to an eleventh aspect, a computer-readable storage medium is provided. The storage medium may be non-volatile. The storage medium includes instructions. When the instructions are run on a communication apparatus, the communication apparatus is enabled to perform the communication method in any possible implementation of the fifth aspect to the eighth aspect.

According to a twelfth aspect, a chip is provided, including at least one processor and an interface circuit. The interface circuit is configured to provide program instructions or data for the at least one processor. The at least one processor is configured to execute the program instructions, to implement the communication method in any possible implementation of the fifth aspect to the eighth aspect.

According to a thirteenth aspect, a communication system is provided, including a sending device and a communication apparatus. The communication apparatus is configured to perform the communication method in any possible implementation of the fifth aspect to the eighth aspect.

**BRIEF DESCRIPTION OF DRAWINGS**

FIG. 1 is a diagram of an architecture of a communication system applicable to an embodiment of this application;
FIG. 2 is a curve diagram of a relationship between time and an amplitude of an FSK signal;
FIG. 3 is a curve diagram of a relationship between time and an amplitude of another FSK signal;
FIG. 4 is a diagram of a structure of a non-coherent FSK receiving device;
FIG. 5 is a diagram of a structure of an FM-AM converter;
FIG. 6 and FIG. 7 each are a diagram of a frequency-amplitude conversion curve of an FM-AM converter;
FIG. 8 is a diagram of a structure of a communication apparatus according to an embodiment of this application;
FIG. 9 is a diagram of a first signal, first data, a second signal, and second data that are sent by a sending device according to an embodiment of this application;
FIG. 10 is a diagram of a frequency-amplitude conversion curve of an FM-AM converter according to an embodiment of this application;
FIG. 11 is a diagram of a structure of another communication apparatus according to an embodiment of this application;

FIG. 12 is a diagram of a structure of still another communication apparatus according to an embodiment of this application;

FIG. 13 is a diagram of a structure of a communication apparatus according to an embodiment of this application;

FIG. 14 is a diagram of a structure of a frequency-amplitude converter according to an embodiment of this application;

FIG. 15 is a diagram of a structure of an RLC resonator according to an embodiment of this application;

FIG. 16 to FIG. 18 each are a diagram of a structure of a communication apparatus according to an embodiment of this application;

FIG. 19 to FIG. 21 each are a diagram of a structure of a communication apparatus according to an embodiment of this application;

FIG. 22 to FIG. 26 each are a diagram of a structure of a communication apparatus according to an embodiment of this application; and

FIG. 27 to FIG. 32 each are a schematic flowchart of a communication method according to an embodiment of this application.

## DESCRIPTION OF EMBODIMENTS

The following describes technical solutions of embodiments of this application with reference to accompanying drawings.

For ease of understanding of embodiments of this application, the following descriptions are first provided before embodiments of this application are described.

First, in embodiments of this application, an "indication" may include a direct indication and an indirect indication, or may include an explicit indication and an implicit indication. Information indicated by a specific signal (for example, the following first signal) is referred to as to-be-indicated information. In a specific implementation process, the to-be-indicated information may be indicated in a plurality of manners, for example, but not limited to, directly indicating the to-be-indicated information, for example, indicating the to-be-indicated information or an index of the to-be-indicated information. Alternatively, the to-be-indicated information may be indirectly indicated by indicating other information, and there is an association relationship between the other information and the to-be-indicated information. Alternatively, only a part of the to-be-indicated information may be indicated, and the other part of the to-be-indicated information is known or pre-agreed on. For example, specific information may alternatively be indicated by using an arrangement sequence that is of all information and that is pre-agreed on (for example, specified in a protocol), to reduce indication overheads to some extent.

Second, the terms "first", "second", and various numbers in the following embodiments are merely used for differentiation for ease of description, but are not intended to limit the scope of embodiments of this application. For example, different signals and branches are distinguished.

Third, "a plurality of" in embodiments of this application means two or more.

The technical solutions of embodiments of this application may be applied to various communication systems, such as a global system for mobile communications (global system for mobile communications, GSM), a code division multiple access (code division multiple access, CDMA) system, a wideband code division multiple access (wideband code division multiple access, WCDMA) system, a general packet radio service (general packet radio service, GPRS), a long term evolution (long term evolution, LTE) system, an LTE frequency division duplex (frequency division duplex, FDD) system, an LTE time division duplex (time division duplex, TDD) system, a universal mobile telecommunications system (universal mobile telecommunications system, UMTS), a worldwide interoperability for microwave access (worldwide interoperability for microwave access, WiMAX) communication system, a future 5th generation (5th generation, 5G) system, or a new radio (new radio, NR) system.

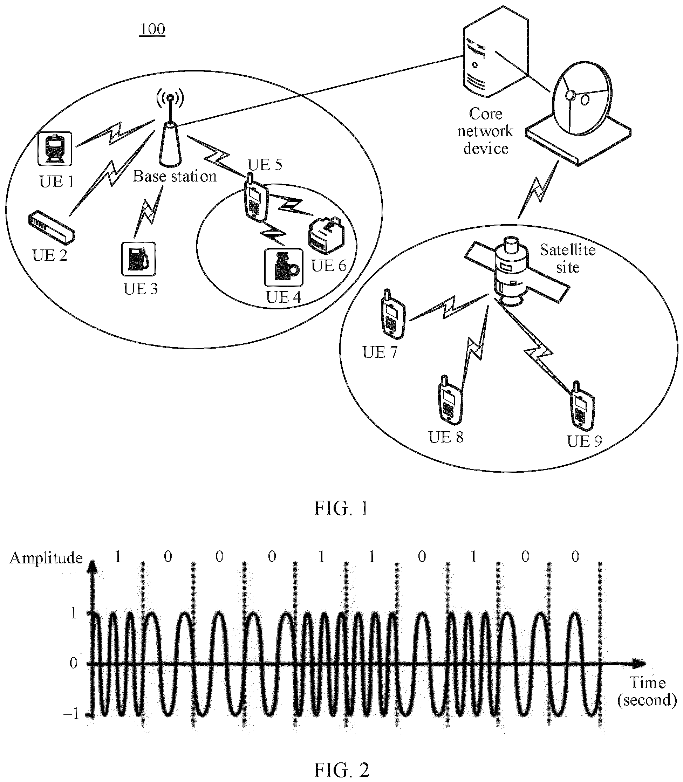

For ease of understanding of embodiments of this application, a communication system applicable to a method provided in embodiments of this application is first described in detail with reference to FIG. 1. FIG. 1 is a diagram of a communication system 100 applicable to a method provided in embodiments of this application.

In an example, as shown in FIG. 1, the communication system 100 may include at least one access network device, for example, a gNB (gNB) in a 5G system and a satellite site that are shown in FIG. 1. The communication system 100 may further include at least one terminal device, for example, user equipment (user equipment, UE) 1 to UE 9 shown in FIG. 1. The access network device may communicate with each terminal device over a radio link. For example, the access network device may send configuration information to the terminal device, and the terminal device may send uplink data to the access network device based on the configuration information. For another example, the access network device may send downlink data to the terminal device. Therefore, a communication system may include the gNB and the UE 1 to UE 6 in FIG. 1, and another communication system may include the satellite site and UE 7 to the UE 9 in FIG. 1. In addition, the base station and the satellite site are connected to a core network device in different manners, and the base station and the satellite site may send data to or receive data from the core network device. In this architecture, there may be a plurality of satellite sites or a plurality of base stations, and the satellite site may also serve UE similar to the UE 1 to the UE 6. This is not limited in this application. A plurality of antennas may be configured for each communication device, for example, the base station, the satellite site, or the UE 1 to the UE 9. The plurality of antennas may include at least one transmit antenna configured to send a signal and at least one receive antenna configured to receive a signal. In addition, each communication device further additionally includes a transmitter chain and a receiver chain. A person of ordinary skill in the art may understand that both the transmitter chain and the receiver chain may include a plurality of components (for example, a processor, a modulator, a multiplexer, a demodulator, a demultiplexer, or an antenna) related to signal sending and receiving. Therefore, the base station may communicate with the UE 11 to the UE 6 by using a multiple-antenna technology, and the satellite site may communicate with the UE 7 to the UE 9 by using the multiple-antenna technology.

In another example, terminal devices in the communication system 100, for example, UE 4 to the UE 6, may also form a communication system. For example, links between UE 5 and the UE 4 and between the UE 5 and the UE 6 may be referred to as sidelinks (sidelinks). For example, the UE 5 may control the UE 4 and the UE 6 to execute corresponding instructions. This is not limited in this application.

It should be further understood that FIG. 1 is merely a simplified diagram used as an example for ease of understanding. The communication system 100 may further include another access network device or terminal device that is not shown in FIG. 1.

It should be understood that the access network device in the wireless communication system may be any device with a wireless transceiver function. The device includes but is not limited to an evolved NodeB (evolved NodeB, eNB or eNodeB), a radio network controller (radio network controller, RNC), a NodeB (NodeB, NB), a base station controller (base station controller, BSC), a base transceiver station (base transceiver station, BTS), a home base station (for example, a home evolved NodeB or a home NodeB, HNB), a baseband unit (baseband unit, BBU), an access point (access point, AP) in a wireless fidelity (wireless fidelity, Wi-Fi) system, a wireless relay node, a wireless backhaul node, a transmission point (transmission point, TP), a transmission reception point (transmission reception point, TRP), and the like. Alternatively, the device may be a gNB or a transmission point (TRP or TP) in the 5G system such as an NR system, may be one antenna panel or a group (including a plurality of antenna panels) of antenna panels of the gNB in the 5G system, or may be a network node, such as a baseband unit (BBU) or a distributed unit (distributed unit, DU), that constitutes a gNB or a transmission point.

In some deployments, the gNB may include a central unit (central unit, CU) and a DU. The gNB may further include a radio unit (radio unit, RU). The CU implements some functions of the gNB, and the DU implements some functions of the gNB. For example, the CU implements functions of a radio resource control (radio resource control, RRC) layer and a packet data convergence protocol (packet data convergence protocol, PDCP) layer, and the DU implements functions of a radio link control (radio link control, RLC) layer, a media access control (media access control, MAC) layer, and a physical (physical, PHY) layer. Information at the RRC layer eventually becomes information at the PHY layer, or is converted from information at the PHY layer. Therefore, in the architecture, higher layer signaling such as RRC layer signaling may also be considered as being sent by the DU or sent by the DU and the CU. It may be understood that the access network device may be a CU node, a DU node, or a device including a CU node and a DU node. In addition, the CU may be classified as an access network device in an access network (radio access network, RAN), or may be classified as an access network device in a core network (core network, CN). This is not limited in this application.

It should be further understood that the terminal device in the wireless communication system may also be referred to as user equipment (user equipment, UE), an access terminal, a subscriber unit, a subscriber station, a mobile station, a remote station, a remote terminal, a mobile device, a user terminal, a terminal, a wireless communication device, a user agent, or a user apparatus. The terminal device in embodiments of this application may be a mobile phone (mobile phone), a tablet computer (pad), a computer with wireless receiving and sending functions, a virtual reality (virtual reality, VR) terminal device, an augmented reality (augmented reality, AR) terminal device, a wireless terminal in industrial control (industrial control), a wireless terminal in self driving (self driving), a wireless terminal in remote medical (remote medical), a wireless terminal in a smart grid (smart grid), a wireless terminal in transportation safety (transportation safety), a wireless terminal in a smart city (smart city), a wireless terminal in a smart home (smart home), or the like. An application scenario is not limited in embodiments of this application.

In embodiments of this application, the terminal device or the access network device includes a hardware layer, an operating system layer running on the hardware layer, and an application layer running on the operating system layer. The hardware layer includes hardware such as a central processing unit (central processing unit, CPU), a memory management unit (memory management unit, MMU), and a memory (also referred to as a main memory). The operating system may be any one or more computer operating systems that implement service processing through a process (process), for example, a Linux® operating system, a Unix® operating system, an Android® operating system, an iOS® operating system, or a Windows® operating system. The application layer includes applications such as a browser, an address book, word processing software, and instant messaging software. In addition, a specific structure of an execution body of a method provided in embodiments of this application is not specifically limited in embodiments of this application, provided that a program that records code of the method provided in embodiments of this application can be run to perform communication according to the method provided in embodiments of this application. For example, the execution body of the method provided in embodiments of this application may be the terminal device, the access network device, or a functional module that can invoke and execute the program and that is in the terminal device or the access network device.

In addition, aspects or features of this application may be implemented as a method, an apparatus, or a product that uses standard programming and/or engineering technologies. The term "product" used in this application covers a computer program that can be accessed from any computer-readable component, carrier, or medium. For example, the computer-readable medium may include but is not limited to a magnetic storage component (for example, a hard disk, a floppy disk, or a magnetic tape), an optical disc (for example, a compact disc (compact disc, CD) or a digital versatile disc (digital versatile disc, DVD)), a smart card, and a flash memory component (for example, an erasable programmable read-only memory (erasable programmable read-only memory, EPROM), a card, a stick, or a key drive). In addition, various storage media described in this specification may represent one or more devices and/or other machine-readable media that are configured to store information. The term "machine-readable medium" may include but is not limited to a radio channel, and various other media that can store, include, and/or carry instructions and/or data.

To facilitate understanding of embodiments of this application, related technical content in this application is briefly described first.

1. A modulation technology is a technology that controls a change of an amplitude, a phase, or a frequency of a carrier based on information that needs to be sent, to perform information transmission through the carrier.

2. An FSK modulation technology is a modulation technology that modulates information on a carrier frequency.

3. A modulation order is used to calculate a quantity of bits that can be represented by each symbol (symbol) of a code pattern. If the modulation order is M, the quantity of bits that can be represented by each symbol (symbol) is $\log_2 M$, that is, one symbol (symbol) may carry $\log_2 M$-bit information. In this case, FSK whose modulation order is M may be referred to as M-FSK.

For example, if the modulation order is 2, one symbol (symbol) may carry 1-bit information. In this case, it may be considered that each symbol in a 01-bit sequence of transmitted information may transmit one bit. An FSK signal at a sending frequency of $f_1$ may represent that "0" is transmitted, and the FSK signal at a sending frequency of $f_2$ may represent that "1" is transmitted. A carrier frequency $f_c$ of the FSK signal is an average value of $f_1$ and $f_2$. For example, FIG. 2 is a curve diagram of a relationship between time and an amplitude of the FSK signal whose modulation order is 2.

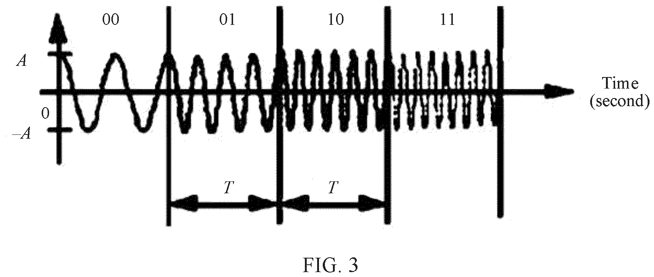

For another example, if the modulation order is 4, one symbol (symbol) may carry 2-bit information. In this case, it may be considered that each symbol in a 01-bit sequence of transmitted information may transmit two bits. An FSK signal at a sending frequency of $f_1$ may represent that "00" is transmitted, the FSK signal at a sending frequency of $f_2$ may represent that "01" is transmitted, the FSK signal at a sending frequency of $f_3$ may represent that "10" is transmitted, and the FSK signal at a sending frequency of may represent that "11" is transmitted. A carrier frequency $f_c$ of the FSK signal is an average value of $f_1$, $f_2$, $f_3$, and $f_4$. For example, FIG. 3 is a curve diagram of a relationship between time and an amplitude of the FSK signal whose modulation order is 4.

It should be noted that FIG. 2 and FIG. 3 are merely two examples of the FSK signal, and should not constitute a limitation on this application.

4. A demodulation technology is a reverse process of the modulation technology. Generally, a receiving device obtains, from a modulated signal (a signal modulated by a sending device) in a signal processing manner, information sent by the sending device.

5. FSK receiving devices may be classified into two basic modes: a coherent FSK receiving device and a non-coherent FSK receiving device. The coherent FSK receiving device needs to recover a carrier. In other words, the coherent FSK receiving device needs to recover the carrier, and demodulate an FSK signal by using the recovered carrier, to obtain demodulated information. However, the non-coherent FSK receiving device does not have such a requirement, in other words, the non-coherent FSK receiving device does not need to recover a carrier, but directly performs demodulation based on a received FSK signal, to obtain demodulated information.

Generally, the coherent FSK receiving device has better demodulation performance but higher power consumption. The non-coherent FSK receiving device has demodulation performance not as good as that of the coherent FSK receiving device, but has advantages of a simple structure and low power consumption. In many communication systems, the non-coherent FSK receiving device is usually selected due to extremely high requirements for low power consumption.

It should be noted that a receiving device in embodiments of this application is a non-coherent FSK receiving device.

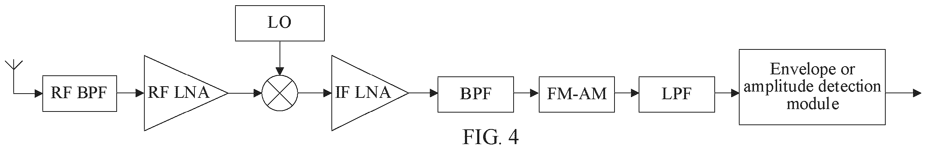

The following uses a non-coherent FSK receiving device shown in FIG. 4 as an example to describe a circuit of the non-coherent FSK receiving device.

For example, as shown in FIG. 4, the non-coherent FSK receiving device includes a radio frequency band-pass filter (radio frequency band-pass filter, RF BPF), a radio frequency signal amplifier (radio frequency low noise amplifier, RF LNA), a local oscillator (local oscillator, LO) (which may also be referred to as a local oscillator), a multiplier, an intermediate frequency signal amplifier (intermediate noise amplifier, IF LNA), a BPF, a frequency modulation (frequency modulation, FM)-amplitude modulation (amplitude modulation, AM) converter, a low-pass filter (low-pass filter, LPF), and an envelope or amplitude detection module (envelop detector).

A process in which the non-coherent FSK receiving device receives an FSK signal (for example, 1 GHz) is roughly as follows: After the FSK signal is received by an antenna of the non-coherent FSK receiving device, the FSK signal is first filtered by using the RF BPF. After signal amplification is performed on a filtered FSK signal by using the RF LNA, frequency mixing is performed by using the multiplier on the FSK signal and a local oscillator signal output by the LO. An FSK signal on which frequency mixing is performed is down-converted to an intermediate frequency (for example, 50 MHz), and then is filtered again by using the BPF. Frequency information of a filtered signal is converted into amplitude information by using the FM-AM converter, and noise is removed by using the LPF. In this case, the envelope or amplitude detection module (envelop detector) can be used to detect modulation information based on the amplitude information.

In an aspect, in the non-coherent FSK receiving device shown in FIG. 4, the FM-AM converter may convert signals at different frequencies into signals with different amplitudes.

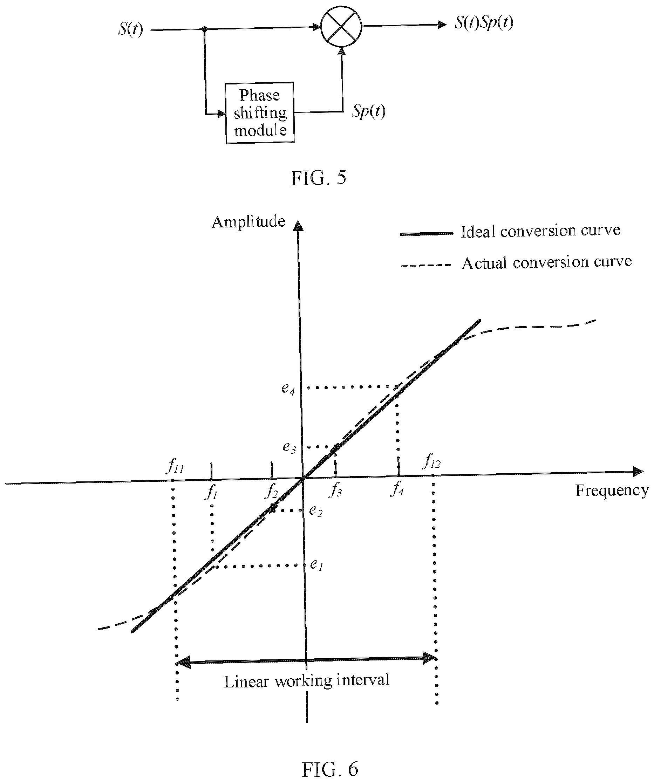

The following describes the FM-AM converter by using an internal structure of the FM-AM converter shown in FIG. 5 as an example. It should be noted that FIG. 5 is merely an example of the internal structure of the FM-AM converter, and should not constitute a limitation on this application.

For example, as shown in FIG. 5, the FM-AM converter includes a phase shifting module and a multiplier. The phase shifting module may perform different phase rotation on signals at different frequencies. A signal $S(t)$ input to the FM-AM converter is divided into two channels. One channel of the signal directly enters the multiplier. The other channel of the signal first enters the phase shifting module. After the signal $S(t)$ passes through the phase shifting module, a signal $Sp(t)$ is obtained. Then, the signal $Sp(t)$ enters the multiplier for frequency mixing with the signal $S(t)$, to obtain a signal $S(t)$ $Sp(t)$ on which frequency mixing is performed.

A phase $\phi_{rot}(f)$ that is of the signal $S(t)$ and that is rotated by the phase shifting module satisfies the following formula:

$$\phi_{rot}(f_{FSK}(t)) = -\frac{\pi}{2} + 2\pi K(f_{FSK}(t) - f_c)$$

$f_c$ is a carrier frequency, and $f_{FSK}(t)$ is a frequency corresponding to the signal $S(t)$.

In this way, an expression of a relationship between time and an amplitude of the signal $Sp(t)$ is as follows:

$$Sp(t) = \cos[2\pi f_c t + \phi(t,\alpha) + \phi_{rot}(f_{FSK}(t))]$$

An expression of a relationship between time and an amplitude of a signal obtained by filtering out a high-frequency component of the signal $S(t)Sp(t)$ is as follows:

$$\cos[\phi_{rot}(f_{FSK}(t))] = \cos[-\frac{\pi}{2} + 2\pi K(f_{FSK}(t) - f_c)] = \sin[2\pi K(f_{FSK}(t) - f_c)]$$

When $2\pi K(f_{FSK}(t)-f_c)$ is small, $\sin[2\pi K(f_{FSK}(t)-f_c)] \approx 2\pi K(f_{FSK}(t)-f_c)$. In this way, the FM-AM converter completes frequency-amplitude conversion.

Regardless of a content structure of the FM-AM converter, the internal structure of the FM-AM converter has a linear working interval. Generally, based on a frequency range of a signal received by the receiving device, it is set that a frequency-amplitude conversion curve of the FM-AM converter is in a linear relationship within a frequency range of an intermediate frequency signal.

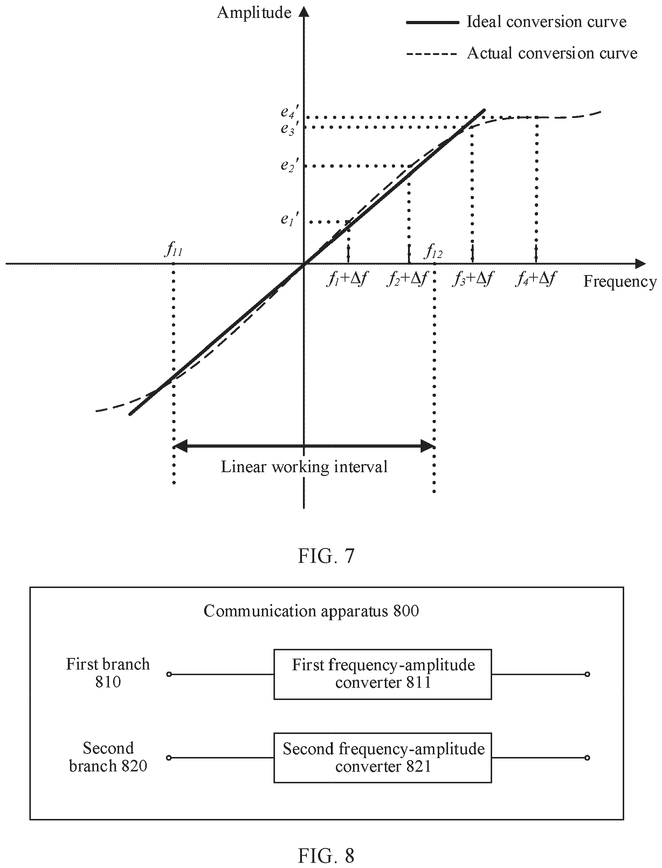

FIG. 6 and FIG. 7 each are a diagram of the frequency-amplitude conversion curve of the FM-AM converter. For example, as shown in FIG. 6 and FIG. 7, in an ideal state, the frequency-amplitude conversion curve of the FM-AM converter is in a linear relationship, as shown by solid lines in FIG. 6 and FIG. 7. In an actual state, the frequency-amplitude conversion curve of the FM-AM converter can only be in an approximately linear relationship in a specific frequency interval, as shown by dashed lines in FIG. 6 and FIG. 7, and the frequency-amplitude conversion curve of the FM-AM converter can be in the approximately linear relationship only in an interval $[f_{11}, f_{12}]$.

For ease of description, the specific frequency interval in which the frequency-amplitude conversion curve of the FM-AM converter is in the approximately linear relationship is referred to as a linear working interval of the FM-AM converter.

If frequencies of a signal obtained by performing frequency mixing on a received signal and the local oscillator signal generated by the LO are $f_1$, $f_2$, $f_3$, and $f_4$, and $f_1$, $f_2$, $f_3$, and $f_4$ all fall within the interval $[f_{11}, f_{12}]$, amplitudes obtained through conversion by the FM-AM converter are respectively $e_1$, $e_2$, $e_3$, and $e_4$. As shown in FIG. 6, if a frequency difference between any two adjacent frequencies in $f_1$, $f_2$, $f_3$, and $f_4$ is the same, an amplitude difference between any two adjacent amplitudes in $e_1$, $e_2$, $e_3$, and $e_4$ is also the same.

However, due to a reason of the LO (for example, stability of the LO), performance of the LO may be unstable, or because performance of the LO is easily affected by an ambient environment such as a temperature, an offset usually exists between an ideal frequency and a frequency of the local oscillator signal generated by the LO. In this case, an offset $\Delta f$ exists between the ideal frequency and the frequency of the signal obtained by performing frequency mixing on the received signal and the local oscillator signal generated by the LO. If the offset $\Delta f$ is large, the frequency of the signal obtained by performing frequency mixing on the received signal and the local oscillator signal generated by the LO exceeds the linear working interval of the FM-AM converter, and the amplitudes obtained through conversion may no longer be in a linear relationship.

For example, if the frequencies of the signal obtained by performing frequency mixing on the received signal and the local oscillator signal generated by the LO are $f_1$, $f_2$, $f_3$, and $f_4$, but because the local oscillator signal generated by the LO has the offset $\Delta f$, the frequencies of the signal obtained by performing frequency mixing on the received signal and the local oscillator signal generated by the LO are changed to $f_1+\Delta f, f_2+\Delta f, f_3+\Delta f$, and $f_4+\Delta f$. For example, as shown in FIG. 7, $f_1 +\Delta f$ and $f_2+\Delta f$ are in the interval $[f_{11}, f_{12}]$, and $f_3+\Delta f$ and $f_4+\Delta f$ exceed the interval $[f_{11}, f_{12}]$. In this case, even if an interval between every two of $f_1+\Delta f, f_2+\Delta f, f_3+\Delta f$, and $f_4+\Delta f$ is the same, an interval between every two of $e_1'$, $e_2'$, $e_3'$, and $e_4'$ is different.

In this case, an error exists in a baseband signal obtained by demodulating the received signal by the receiving device. Consequently, demodulation performance of the receiving device is severely affected.

Therefore, an embodiment of this application provides a communication apparatus. The communication apparatus may perform frequency offset correction on a local oscillator signal generated by the communication apparatus. In this way, an error of a baseband signal obtained by demodulating a received signal by the communication apparatus can be reduced, thereby improving demodulation performance of a receiving device.

A type of the communication apparatus in this embodiment is not limited in this application. For example, the communication apparatus may be any device shown in FIG. 1, or the communication apparatus may be an apparatus in any device shown in FIG. 1.

For example, the communication apparatus includes two branches. One branch performs frequency offset correction on the local oscillator signal, and the other branch demodulates the received signal based on a local oscillator signal obtained through correction.

The two branches may work in a time division manner, or may work simultaneously. For ease of description, that the two branches work in the time division manner is denoted as Embodiment 1, and that the two branches work simultaneously is denoted as Embodiment 2.

In an example, the two branches may work in the time division manner by using switches. Specifically, at least one switch is disposed on each branch. When one of the two branches needs to work, a switch on the branch may be turned on, so that the branch is connected to another module of the communication apparatus. When the other of the two branches needs to work, the switch on the branch may be turned off, and a switch on the other branch is turned on, so that the branch is disconnected from the another module of the communication apparatus, and the other branch is connected to the another module of the communication apparatus.

The following describes the communication apparatus in detail by using Embodiment 1 and Embodiment 2 as examples.

**Embodiment 1**

FIG. 8 is a diagram of a structure of a communication apparatus according to an embodiment of this application.

The communication apparatus 800 shown in FIG. 8 is configured to receive a first signal and a second signal, where both the second signal and the first signal are from a same device (which may be referred to as a sending device), and the second signal indicates the communication apparatus to enter a connected state.

The first signal is used to perform frequency offset correction on a local oscillator signal (a first local oscillator signal described below) generated by the communication apparatus 800.

In an example, the first signal may carry no content.

In another example, the first signal may alternatively carry content.

For example, the first signal may carry an identifier of a cell. The cell is an area served by the sending device, and the identifier of the cell is used to assist a receiving device in determining whether information is received from a correct sending device.

It should be noted that, if the receiving device is in coverage of a sending device, the sending device may be understood as the correct sending device described above. Alternatively, if the receiving device has established a connection to a sending device, the sending device may also be understood as the correct sending device described above.

Whether the first signal carries content is not limited in this embodiment of this application. In addition, a name of the first signal is not limited in this embodiment of this application. For example, the first signal may also be referred to as another signal such as a reference signal, and a signal that has a same function as the first signal may be considered as the first signal.

In addition, a name of the second signal is not limited in this embodiment of this application. For example, the second signal may also be referred to as another signal such as a wake-up signal, and a signal that has a same function as the second signal may be considered as the second signal.

A manner of sending the first signal and the second signal is not limited in this embodiment of this application.

In an example, the sending device may periodically send the first signal and the second signal. Correspondingly, the communication apparatus 800 may periodically receive the first signal and the second signal that are sent by the sending device.

For example, a periodicity for sending the first signal and/or the second signal by the sending device may be notified by the sending device to the communication apparatus 800; or a periodicity for sending the first signal and/or the second signal by the sending device may be specified or configured in advance. This is not limited in this embodiment of this application.

A value of the periodicity for sending the first signal and the second signal is not limited in this embodiment of this application. The value may be determined based on an actual situation.

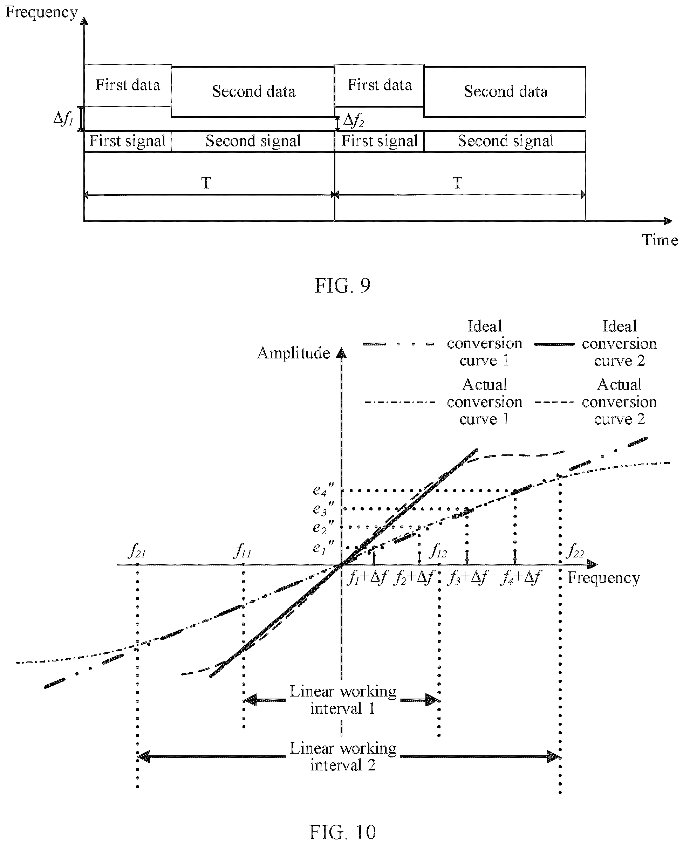

Optionally, in this example, as shown in FIG. 9, in a periodicity T, the sending device may first send the first signal, and then send the second signal.

It should be noted that FIG. 9 is described by using an example in which the sending device immediately sends the second signal after completing sending of the first signal. This should not constitute a limitation on this application. For example, the sending device may alternatively send the second signal before the sending of the first signal is completed. Alternatively, the sending device may send the second signal since the sending of the first signal is completed for a period of time.

Optionally, in this example, the sending device may further send first data and second data to the communication apparatus 800. Correspondingly, the communication apparatus is further configured to receive the first data and the second data.

A manner of sending the first data and the second data is not limited in this embodiment of this application.

For example, the sending manner of sending the first signal and/or the second signal by the sending device may be notified by the sending device to the communication apparatus 800; or the sending manner of sending the first signal and/or the second signal by the sending device may be specified or configured in advance. This is not limited in this embodiment of this application.

For example, the sending device sends the first signal and the first data in a frequency division multiplexing (frequency division multiplexing, FDM) manner.

For example, the sending device may also send the second signal and the second data in the FDM manner.

It should be noted that, when the sending device sends the first signal and the first data in the FDM manner, and sends the second signal and the second data in the FDM manner, as shown in FIG. 9, a frequency guard interval $\Delta f_1$ between the first signal and the first data is greater than a frequency guard interval $\Delta f_2$ between the second signal and the second data.

For example, the frequency guard interval $\Delta f_1$ between the first signal and the first data and/or the frequency guard interval $\Delta f_2$ between the second signal and the second data may be notified by the sending device to the communication apparatus 800; or the frequency guard interval $\Delta f_1$ between the first signal and the first data and/or the frequency guard interval $\Delta f_2$ between the second signal and the second data may be specified or configured in advance. This is not limited in this embodiment of this application.

The first signal is used to perform frequency offset correction on the first local oscillator signal, and the second signal indicates the communication apparatus to enter the connected state. Therefore, the communication apparatus 800 first performs frequency offset correction on the first local oscillator signal based on the first signal, and then demodulates the received second signal based on a second local oscillator signal obtained by performing frequency offset correction on the first local oscillator signal. Because a frequency offset exists in a process in which the communication apparatus 800 performs frequency offset correction on the first local oscillator signal, the frequency guard interval between the first signal and the first data is set to be larger (relative to the frequency guard interval between the second signal and the second data), so that first data normally transmitted on an adjacent frequency band cannot enter a first branch described below. In a process in which the received second signal is demodulated based on the second local oscillator signal obtained by performing frequency offset correction on the first local oscillator signal, because frequency offset correction has been performed on the first local oscillator signal, a frequency offset value of the obtained second local oscillator signal is less than a frequency offset value of the first local oscillator signal. Therefore, the frequency guard interval between the second signal and the second data is set to be smaller (relative to the frequency guard interval between the first signal and the first data), so that second data normally transmitted on an adjacent frequency band cannot enter a second branch described below. In addition, the smaller guard interval helps improve system resource utilization.

In an example, to reduce power consumption of the communication apparatus, two links are usually disposed in the communication apparatus. One link is used to receive normally received and sent data. When the link is enabled, power consumption of the communication apparatus is large. The other link is used when the communication apparatus is in a non-connected state. When the other link is enabled, power consumption of the communication apparatus is small. In other words, to reduce power consumption of the communication apparatus 800, the communication apparatus 800 may respectively receive signals (for example, the first signal and the second signal) and data (for example, the first data and the second data) over two links.

Specifically, when the communication apparatus 800 is in the non-connected state, a first link of the communication apparatus 800 is in a working state. In this case, a second link of the communication apparatus 800 is in a disabled state. When the communication apparatus 800 needs to enter the connected state, the communication apparatus 800 needs to first enable the second link. For example, when the communication apparatus 800 is in the non-connected state, the communication apparatus 800 receives the first signal and the second signal over the first link. After the communication apparatus 800 receives, in the second signal, indication information indicating to receive data or enter the connected state, the communication apparatus 800 triggers the communication apparatus 800 to enable the second link. Further, after exchanging information with the sending device, the communication apparatus 800 enters the connected state, and then receives the first data and the second data over the second link.

For example, the first link described above may also be referred to as a wake-up radio (wake-up radio, WUR), and the second link may also be referred to as a main radio (main radio). This is not limited in this application.

It should be noted that the communication apparatus 800 may alternatively receive signals (for example, the first signal and the second signal) and data (for example, the first data and the second data) over one link. This is not limited in this application.

Optionally, in an example, if the first signal carries content, to enable the communication apparatus 800 to have better demodulation performance for the first signal, the sending device may send the first signal at a higher transmit power (relative to a transmit power of the second signal), so that the communication apparatus 800 can obtain a first signal with strong signal strength, and obtain modulation information of the first signal based on the first signal.

Optionally, in an example, if the first signal carries content, to enable the communication apparatus 800 to have better demodulation performance for the first signal, the sending device may send the first signal at a lower modulation order (relative to a modulation order of the second signal), a lowest modulation order (for example, a modulation order of 2), or a single frequency. A lower modulation order indicates less information carried in each symbol (symbol) of the first signal and a smaller quantity of amplitudes converted from frequencies by the communication apparatus 800. In this way, in a same interval, a smaller quantity of amplitudes indicates a larger distance between amplitudes. Therefore, the communication apparatus 800 has better demodulation performance for the first signal.

For example, as shown in FIG. 8, the communication apparatus 800 includes the first branch 810 and the second branch 820.

The first branch 810 includes a first frequency-amplitude converter 811. The first frequency-amplitude converter 811 is configured to obtain first amplitude information of a third signal, where the third signal is a signal obtained by performing frequency mixing on the first signal and the first local oscillator signal. In other words, the third signal obtained by performing frequency mixing on the first signal and the first local oscillator signal is input to the first frequency-amplitude converter 811, and the first frequency-amplitude converter 811 may obtain the first amplitude information of the third signal.

The second branch 820 is configured to demodulate a fourth signal, where the fourth signal is a signal obtained by performing frequency mixing on the second signal and the second local oscillator signal, and the second local oscillator signal is a signal obtained by performing frequency offset correction on the first local oscillator signal based on the first amplitude information. In other words, based on the first amplitude information obtained by the first frequency-amplitude converter 811, the second local oscillator signal may be obtained by performing frequency offset correction on the first local oscillator signal, and the fourth signal obtained by performing frequency mixing on the second signal and the second local oscillator signal is input to the second branch 820, so that the fourth signal can be demodulated through the second branch 820.

In addition, the second branch 820 includes a second frequency-amplitude converter 821, and a linear working interval corresponding to the second frequency-amplitude converter 821 is smaller than a linear working interval corresponding to the first frequency-amplitude converter 811.

As described above, the communication apparatus 800 first obtains, by using the first frequency-amplitude converter 811 on the first branch 810, the first amplitude information of the third signal obtained by performing frequency mixing on the first signal and the first local oscillator signal. Then, the communication apparatus 800 demodulates, through the second branch 821, the fourth signal obtained by performing frequency mixing on the second local oscillator signal and the second signal, where the second local oscillator signal is the signal obtained by performing frequency offset correction on the first local oscillator signal based on the first amplitude information. Because the first local oscillator signal has a frequency offset, the linear working interval corresponding to the first frequency-amplitude converter 811 on the first branch 810 is set to be larger than the linear working interval corresponding to the second frequency-amplitude converter 821, so that a frequency of the third signal obtained by performing frequency mixing on the first signal and the first local oscillator signal does not exceed the linear working interval corresponding to the first frequency-amplitude converter 811. Therefore, the first frequency-amplitude converter 811 can accurately obtain the first amplitude information of the third signal, to subsequently perform accurate frequency offset correction on the first local oscillator signal based on the first amplitude information.

Further, the communication apparatus 800 demodulates, through the second branch 820, the fourth signal obtained by performing frequency mixing on the second local oscillator signal and the second signal. Because the second local oscillator signal is the signal obtained by performing frequency offset correction on the first local oscillator signal, a frequency offset value of the fourth signal is less than a frequency offset value of a signal obtained by performing frequency mixing on the first local oscillator signal and the second signal. In this way, when the linear working interval corresponding to the second frequency-amplitude converter 821 on the second branch 820 is set to be smaller than the linear working interval of the first frequency-amplitude converter 811, the fourth signal can still be accurately demodulated. Therefore, demodulation performance of the communication apparatus 800 is not severely affected.

Optionally, in an example, if both an internal structure of the first frequency-amplitude converter 811 and an internal structure of the second frequency-amplitude converter 821 are the internal structure of the FM-AM converter shown in FIG. 5, the linear working interval corresponding to the first frequency-amplitude converter 811 and the linear working interval corresponding to the second frequency-amplitude converter 821 may be set based on a slope of a frequency-amplitude conversion curve of a phase shifting module of the FM-AM converter.

For example, as shown in FIG. 10, an ideal conversion curve 1 is an ideal conversion curve corresponding to a first frequency-phase curve, and an actual conversion curve 1 is an actual conversion curve corresponding to the first frequency-phase curve. An ideal conversion curve 2 is an ideal conversion curve corresponding to a second frequency-phase curve, and an actual conversion curve 2 is an actual conversion curve corresponding to the second frequency-phase curve. It can be seen that a slope of the actual conversion curve 2 is greater than that of the actual conversion curve 1, but a linear working interval corresponding to the actual conversion curve 2 is smaller than that of the actual conversion curve 1. Therefore, a linear working interval corresponding to a frequency-amplitude converter may be set based on the slope of the frequency-amplitude conversion curve.

Specifically, the first frequency-amplitude converter 811 includes a first phase shifting unit, and the first phase shifting unit introduces different phase shifts to signals at different frequencies based on the first frequency-phase curve. The second frequency-amplitude converter 821 includes a second phase shifting unit, the second phase shifting unit introduces different phase shifts to signals at different frequencies based on the second frequency-phase curve, and a slope of the second frequency-phase curve is greater than a slope of the first frequency-phase curve.

For example, if in an ideal case, frequencies of the signal obtained by performing frequency mixing on the first local oscillator signal and the first signal are $f_1$, $f_2$, $f_3$, and $f_4$, but in an actual case, the first local oscillator signal has a frequency offset, and the frequency offset is $\Delta f$, the frequencies of the signal obtained by performing frequency mixing on the first local oscillator signal and the first signal are changed to $f_1+\Delta f$, $f_2+\Delta f$, $f_3+\Delta f$, and $f_4+\Delta f$. As shown in FIG. 10, $f_1+\Delta f$, $f_2+\Delta f$, $f_3+\Delta f$, and $f_4+\Delta f$ are all within a linear interval $[f_{21}, f_{22}]$ of the actual conversion curve 1. In this case, a frequency interval between any two adjacent frequencies in $f_1+\Delta f$, $f_2+\Delta f$, $f_3+\Delta f$, and $f_4+\Delta f$ is the same, and an interval between any two adjacent amplitudes in amplitudes $e_1''$, $e_2''$, $e_3''$, and $e_4''$ obtained based on the actual conversion curve 2 is also the same. In comparison with the ideal amplitudes shown in FIG. 6, because the frequency offset exists, the amplitudes actually obtained in FIG. 10 have an overall offset. However, because the amplitudes are still in the linear working interval corresponding to the first frequency-amplitude converter 811, frequency offset correction can also be accurately performed on the first local oscillator signal subsequently based on a slope of the actual conversion curve 1 and offset values of $e_1''$, $e_2''$, $e_3''$, and $e_4''$.

In addition, because a slope of the actual conversion curve 2 is greater than the slope of the actual conversion curve 1, a Euclidean distance between amplitudes converted based on the actual conversion curve 2 is greater than a Euclidean distance between amplitudes converted based on the actual conversion curve 1. In addition, in a same interval, a shorter Euclidean distance indicates a poorer anti-noise capability of demodulation. Therefore, in a process in which the fourth signal is demodulated based on the actual conversion curve 2, because a Euclidean distance between amplitudes is long, high demodulation performance can be obtained.

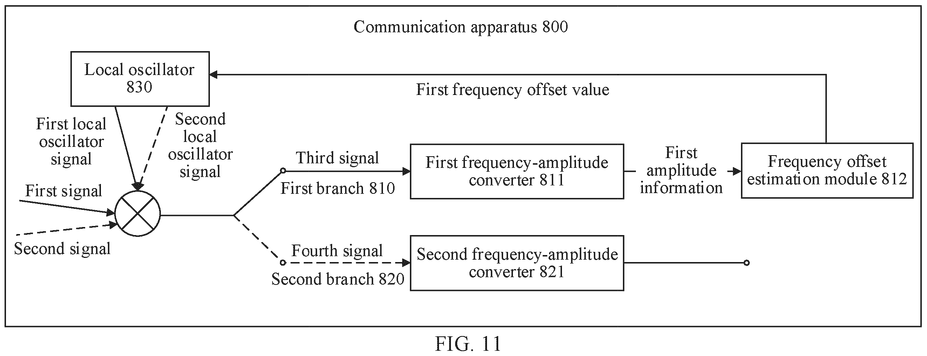

Optionally, in an example, as shown in FIG. 11, the communication apparatus 800 further includes a frequency offset estimation module 812 and a local oscillator 830. The first frequency-amplitude converter 811 is further configured to send the first amplitude information to the frequency offset estimation module 812. The frequency offset estimation module 812 is configured to: obtain a first frequency offset value based on the first amplitude information, and send the first frequency offset value to the local oscillator 830. The local oscillator 830 is configured to perform frequency offset correction on the first local oscillator signal based on the first frequency offset value, to obtain the second local oscillator signal.

In an example, the frequency offset estimation module 812 may obtain the first frequency offset value based on the first amplitude information and first ideal amplitude information.

The first ideal amplitude information may be understood as amplitude information corresponding to the third signal obtained by performing frequency mixing on the first signal and the first local oscillator signal, when the first local oscillator signal has no frequency offset.

It should be noted that the first ideal amplitude information may be sent by the sending device to the communication apparatus 800. Alternatively, the first ideal amplitude information may be calculated by the receiving device based on a sending frequency of the first signal and a slope of a first frequency-amplitude conversion curve.

Optionally, in an example, that the second branch 820 is configured to demodulate the fourth signal includes: obtaining third amplitude information of the fourth signal by using the second frequency-amplitude converter 821 on the second branch 820, and obtaining modulation information of the fourth signal based on the third amplitude information.

How the second branch 820 obtains the modulation information of the fourth signal based on the third amplitude information is not limited in this embodiment of this application.

In an example, if the sending device performs frequency shift keying modulation on the second signal, the second branch 820 obtains, based on the third amplitude information of the fourth signal, the modulation information carried in the fourth signal.

In another example, if the sending device performs differential frequency modulation on the second signal, in other words, a differential frequency modulation scheme is used for the second signal, the second branch 820 first obtains, based on the third amplitude information of the fourth signal, a frequency difference of the fourth signal transmitted in adjacent time units, where a frequency of the fourth signal transmitted in an $i^{th}$ time unit is: $f(i)=\text{mod}[f(i\text{-}1)+\Delta f_1(i)$, B 1], $\Delta f_1(i)$ is a difference between a frequency of an $i^{th}$ fourth signal and a frequency of an $(i\text{-}1)^{th}$ fourth signal in a sequence of the fourth signal, B 1 is a preset first bandwidth value, and $i$ is an integer greater than 1; and then obtains, based on the frequency difference of the fourth signal, the modulation information carried in the fourth signal.

It should be noted that when i is 2, $f(i\text{-}2)=f(1)$ may be any value. A specific value of $f(1)$ is not limited in this embodiment of this application.

In addition, a time unit described in all embodiments of this application may be understood as a periodicity of an element in a bit sequence. A value of the time unit is not limited in this application. For example, the time unit may be a symbol.

Because a time interval between two consecutive time units is extremely short, even if a residual frequency offset exists in the local oscillator signal generated by the communication apparatus, residual frequency offsets of local oscillator signals generated in the two consecutive time units by the communication apparatus may be considered to be the same. In this way, the residual frequency offset of the local oscillator signal generated by the communication apparatus may be canceled by subtracting between frequencies of the fourth signal in the two consecutive time units (that is, the differential frequency modulation scheme). Therefore, the demodulation performance of the communication apparatus is not further affected.

For example, if the sending device performs differential frequency modulation on the second signal based on a modulation order of 4, every two bits in a 0/1-bit sequence of the transmitted second signal may be mapped to one symbol (symbol), and there are four possibilities for every two bits: "00", "01", "10", and " 11". The sending device may map every two bits in the bit sequence of the second signal to one first frequency difference, and modulate the second signal based on the first frequency difference to which every two bits in the bit sequence are mapped.

Table 1 shows a mapping relationship between every two bits in the bit sequence and the first frequency difference according to an embodiment of this application.

It should be noted that Table 1 is merely an example, and should not constitute a limitation on this application. A value of the first frequency difference to which every two bits in the bit sequence are mapped is not limited in this embodiment of this application.

**Table 1**

| Sequence | First frequency difference |
|---|---|
| 00 | 0 kHz |
| 01 | 50 kHz |
| 10 | 100 kHz |
| 11 | 150 kHz |

For example, the following assumption is made: (1) The bit sequence of the second signal transmitted by the sending device is "01100011". (2) When i is 2, $f(i\text{-}1)=f(1)=20$ kHz. In this case, $f(1)$ may be referred to as an initial frequency of the second signal. (3) B1=200 kHz. (4) The mapping relationship between every two bits in the bit sequence and the first frequency difference is the mapping relationship shown in Table 1. In this case, the sending device needs to modulate the second signal based on the bit sequence of the second signal. A specific process is as follows.

S1: After the sending device modulates the second signal transmitted on a symbol corresponding to a 1st bit ("0") and a 2nd bit ("1") in the bit sequence of the second signal, an obtained frequency is 20 kHz (the initial frequency)+50 kHz (a first frequency difference to which the 1st bit ("0") and the 2nd bit ("1") are mapped)=70 kHz.

S2: After the sending device modulates the second signal transmitted on a symbol corresponding to a 3rd bit ("1") and a 4th bit ("0") in the bit sequence of the second signal, an obtained frequency is 70 kHz (the frequency obtained by modulating the second signal transmitted on the symbol corresponding to the 1st bit ("0") and the 2nd bit ("1"))+100 kHz (a first frequency difference to which the 3rd bit (" 1") and the 4th bit ("0") are mapped)=170 kHz.

S3: After the sending device modulates the second signal transmitted on a symbol corresponding to a 5th bit ("0") and a 6th bit ("0") in the bit sequence of the second signal, an obtained frequency is 170 kHz (the frequency obtained by modulating the second signal transmitted on the symbol corresponding to the 3rd bit ("1") and the 4th bit ("0"))+0 kHz (a first frequency difference to which the 5th bit ("0") and the 6th bit ("0") are mapped)=170 kHz.

S4: After the sending device modulates the second signal transmitted on a symbol corresponding to a 7th bit ("1") and an 8th bit ("1 ") in the bit sequence of the second signal, an obtained frequency is 170 kHz (the frequency obtained by modulating the 5th bit ("0") and the 6th bit ("0"))+150 kHz (a first frequency difference to which the 7th bit ("1") and the 8th bit ("1") are mapped)=320 kHz. However, because 320 kHz exceeds the preset first bandwidth value B1, the frequency obtained by modulating the second signal transmitted on the symbol corresponding to the 7th bit ("1") and the 8th bit ("1") in the bit sequence of the second signal needs to be adjusted based on $f(i)=mod[f(i-1)+\Delta f_1(i), B1]$. Finally, the frequency obtained by modulating the second signal transmitted on the symbol corresponding to the 7th bit ("1") and the 8th bit ("1") in the bit sequence of the second signal is mod[320, 200]=120 kHz.

In this way, frequencies obtained by modulating the bit sequence of the transmitted second signal by the sending device are shown in Table 2.

**Table 2**

| Sequence | Frequency |
|----------|-----------|
| 00 | 70 kHz |
| 01 | 170 kHz |
| 10 | 170 kHz |
| 11 | 120 kHz |

It should be noted that the bit sequence of the second signal sent by the sending device may be information bits sent by the sending device to the communication apparatus 800; or the bit sequence of the second signal sent by the sending device may be specified or configured in advance. This is not limited in this application.

Correspondingly, a process in which the communication apparatus 800 demodulates the fourth signal (the signal obtained by performing frequency mixing on the second signal and the second local oscillator signal) includes the following steps.

S1': Obtain, based on the third amplitude information of the fourth signal, that frequencies corresponding to four symbols of the fourth signal are successively 70 kHz, 170 kHz, 170 kHz, and 120 kHz. The four symbols include the symbol corresponding to the 1st bit ("0") and the 2nd bit ("1"), the symbol corresponding to the 3rd bit ("1") and the 4th bit ("0"), the symbol corresponding to the 5th bit ("0") and the 6th bit ("0"), and the symbol corresponding to the 7th bit ("1 ") and the 8th bit ("1").

S2': Obtain a frequency difference of the fourth signal transmitted in adj acent time units, to be specific, obtain a frequency difference of the second signal transmitted on two adjacent symbols in the bit sequence of the fourth signal, and obtain modulation information based on the mapping relationship between every two bits in the bit sequence of the second signal and the first frequency difference. Because the sending device modulates the second signal based on Table 1, the mapping relationship between every two bits in the bit sequence of the second signal and the first frequency difference herein is queried for based on Table 1.

Specifically, a difference between a frequency of the fourth signal transmitted on a first symbol of the fourth signal and the initial frequency of the second signal is: 70 kHz-20 kHz=50 kHz. It can be learned from Table 1 that the frequency difference 50 kHz corresponds to bits "01".

A difference between a frequency of the fourth signal transmitted on a 2nd symbol of the fourth signal and a frequency of the fourth signal transmitted on the 1st symbol of the fourth signal is: 170 kHz-70 kHz=150 kHz. It can be learned from Table 1 that the frequency difference 150 kHz corresponds to bits "11".

A difference between a frequency of the fourth signal transmitted on a 3rd symbol in the bit sequence of the fourth signal and a frequency of the fourth signal transmitted on the second symbol of the fourth signal is: 170 kHz-170 kHz=0 kHz. It can be learned from Table 1 that the frequency difference 0 kHz corresponds to bits "00".

Because a frequency of the fourth signal transmitted on a 4th symbol in the bit sequence of the fourth signal is less than the frequency of the fourth signal transmitted on the 3rd symbol in the bit sequence of the fourth signal, the sending device adjusts the frequency of the fourth signal in a process of modulating the fourth signal transmitted on the 4th symbol of the fourth signal. Therefore, the communication apparatus 800 needs to recover the frequency based on $f(i)$=mod[$f(i-1)$+$\Delta f_1(i)$, B1]. Specifically, a frequency difference between the frequency of the fourth signal transmitted on the 4th symbol in the bit sequence of the fourth signal and the frequency of the fourth signal transmitted on the 3rd symbol in the bit sequence of the fourth signal is 120 kHz+200 kHz-170 kHz=150 kHz. It can be learned from Table 1 that the frequency difference 150 kHz corresponds to elements "11".

In this way, the bit sequence of the fourth signal obtained by the communication apparatus 800 is "01", "10", "00", and "11", to complete demodulation of the fourth signal.

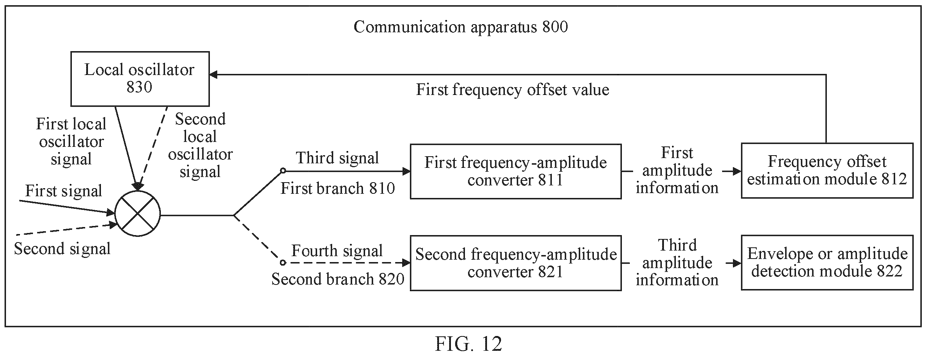

Optionally, in an example, as shown in FIG. 12, the second branch 820 further includes an envelope or amplitude detection module 822, configured to obtain the modulation information of the fourth signal based on the third amplitude information.

Optionally, in an example, if the first signal carries content, the first branch 810 is further configured to demodulate the third signal. Specifically, modulation information of the third signal is obtained based on the first amplitude information of the third signal.

How the first branch 810 obtains the modulation information of the third signal based on the first amplitude information is not limited in this embodiment of this application.

In an example, if the sending device performs frequency shift keying modulation on the first signal, the first branch 810 obtains, based on the first amplitude information of the third signal, the modulation information carried in the third signal.

In another example, if the sending device performs differential frequency modulation on the first signal, in other words, a differential frequency modulation scheme is used for the first signal, the first branch 810 first obtains, based on the first amplitude information of the third signal, a frequency difference of the third signal transmitted in adjacent time units, where a frequency of the third signal transmitted in a $j$th time unit is: $f(j)$=mod[$f(j-1)$+$\Delta f_1(j)$, B3], $\Delta f_1(j)$ is a frequency difference between a frequency of a $j$th third signal and a frequency of a $(j-1)$th third signal in a sequence of the third signal, B3 is a preset third bandwidth value, and $j$ is an integer greater than 1; and then obtains, based on the frequency difference of the third signal, the modulation information carried in the third signal.

It should be noted that when $j$ is 2, $f(j-1)$=$f(1)$ may be any value. A specific value of $f(1)$ is not limited in this embodiment of this application.

Optionally, in an example, as shown in FIG. 11, the first branch 810 further includes an envelope or amplitude detection module 822, configured to obtain modulation information of the third signal based on the first amplitude information.

### Embodiment 2

It can be learned from the foregoing descriptions of Embodiment 1 that, in Embodiment 1, the communication apparatus 800 performs frequency offset correction on the first local oscillator signal based on the first signal through the first branch 810. Then, the communication apparatus 800 demodulates the received signal based on the second signal through the second branch 820. In other words, the sending device needs to send two signals (the first signal and the second signal), and the communication apparatus 800 performs frequency offset correction on the first local oscillator signal and demodulates the received signals in a time division manner based on the two received signals through two branches (the first branch 810 and the second branch 820).

Further, to reduce signaling overheads of the sending device, the sending device may alternatively send only one signal (the second signal). In this way, the communication apparatus 800 performs frequency offset correction on the first local oscillator signal and demodulates the received signal simultaneously based on the received signal through the two branches (the first branch 810 and the second branch 820). In this case, this solution is referred to as Embodiment 2.

In comparison with Embodiment 1, Embodiment 2 has the following differences:

1. The communication apparatus 800 is configured to receive only the second signal.
2. The first frequency-amplitude converter 811 on the first branch 810 of the communication apparatus 800 is configured to obtain second amplitude information of a fifth signal, where the fifth signal is a signal obtained by performing frequency mixing on the second signal and the first local oscillator signal.
3. The second branch 820 of the communication apparatus 800 is configured to demodulate a sixth signal, where the sixth signal is a signal obtained by performing frequency mixing on the second signal and the second local oscillator signal, and the second local oscillator signal is a signal obtained by performing frequency offset correction on the first local oscillator signal based on the second amplitude information.

Optionally, in an example, the second local oscillator signal is a signal obtained by performing frequency offset correction on the first local oscillator signal based on the second amplitude information and second ideal amplitude information.

The second ideal amplitude information may be understood as amplitude information corresponding to the fifth signal obtained by performing frequency mixing on the second signal and the first local oscillator signal, when the first local oscillator signal has no frequency offset.

It should be noted that the second ideal amplitude information may be notified by the sending device to the communication apparatus 800. Alternatively, the second ideal amplitude information may be calculated by the receiving device based on a sending frequency of the second signal and a slope of a second frequency-amplitude conversion curve.

In this way, the related descriptions in Embodiment 1 are replaced with the following four points: (1) That the communication apparatus 800 is configured to receive the first signal and the second signal is replaced with that the communication apparatus 800 is configured to receive the second signal. (2) The third signal is replaced with the fifth signal. (3) The first amplitude information is replaced with the second amplitude information, and the first frequency offset value is replaced with a second frequency offset value. (4) The fourth signal is replaced with the sixth signal. In this way, related descriptions in Embodiment 2 may be obtained. Therefore, details are not described herein again.

## Embodiment 3

It can be learned from the foregoing descriptions of Embodiment 1 and Embodiment 2 that two branches need to be disposed in the communication apparatus 800, and one frequency-amplitude converter needs to be disposed on each branch, so that one branch can perform frequency offset correction on a local oscillator signal generated by the communication apparatus 800, and the other branch can demodulate a signal received by the communication apparatus 800.

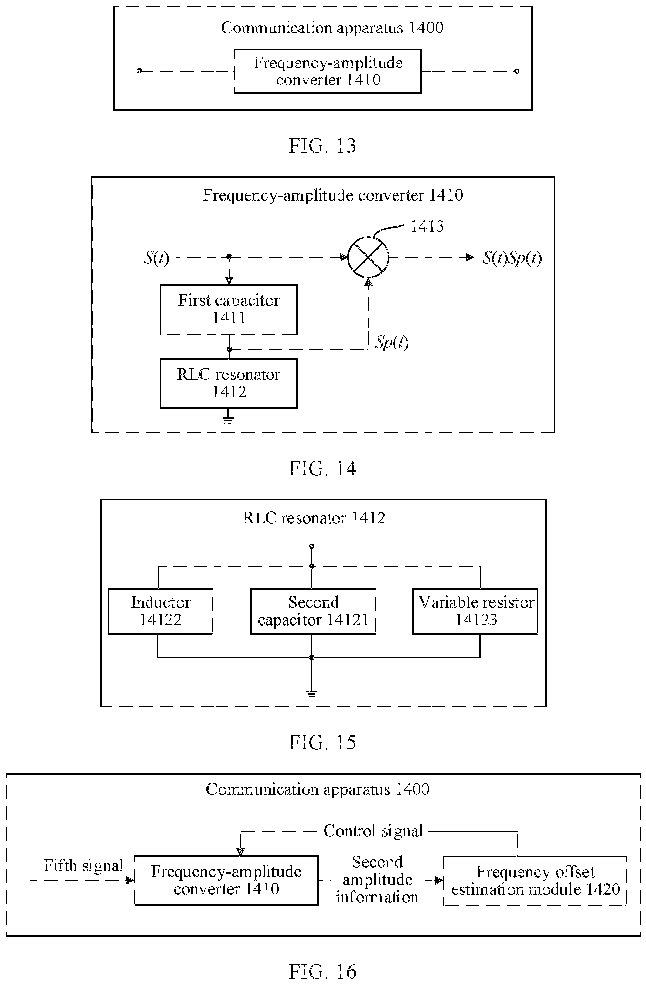

Further, to reduce complexity and costs of a system of the communication apparatus 800, an embodiment of this application further provides another communication apparatus. Only one line needs to be disposed in the communication apparatus, and one frequency-amplitude converter whose linear working interval can be adjusted based on a frequency offset of the local oscillator signal generated by the communication apparatus is disposed on the line. In this way, the communication apparatus needs only one path and one frequency-amplitude converter, to perform frequency offset correction on the local oscillator signal generated by the communication apparatus and accurately demodulate the signal received by the communication apparatus. The following describes the communication apparatus with reference to FIG. 13 to FIG. 26.

FIG. 13 is a diagram of a structure of another communication apparatus 1400 according to an embodiment of this application.

A type of the communication apparatus 1400 in this embodiment is not limited in this application. For example, the communication apparatus 1400 may be any device shown in FIG. 1, or the communication apparatus 1400 may be an apparatus in any device shown in FIG. 1.

The communication apparatus 1400 shown in FIG. 13 is configured to receive a second signal, where the second signal indicates the communication apparatus to enter a connected state.

In an example, a sending device may periodically send the second signal. Correspondingly, the communication apparatus 1400 may periodically receive the second signal sent by the sending device.

For a part of the second signal that is not described in this embodiment, refer to the related descriptions in Embodiment 1. Details are not described herein again.

Optionally, the sending device may further send data to the communication apparatus 1400. Correspondingly, the communication apparatus 1400 is further configured to receive the data.

A manner of sending the data is not limited in this embodiment of this application.

For example, the sending device sends the second signal and the data in an FDM manner. Optionally, in this example, a frequency guard interval may be set between the second signal and the data.

In an example, to reduce power consumption of the communication apparatus 1400, the communication apparatus 1400 may respectively receive the second signal and the data over two links.

Specifically, when the communication apparatus 1400 is in a non-connected state, a first link of the communication apparatus 1400 is in a working state. In this case, a second link of the communication apparatus 1400 is in a disabled state. When the communication apparatus 1400 needs to enter the connected state, the communication apparatus 1400 needs to first enable the second link. For example, when the communication apparatus 1400 is in the non-connected state, the communication apparatus 1400 receives the second signal over the first link. After the communication apparatus 1400 receives, in the second signal, indication information indicating to receive the data or enter the connected state, the communication apparatus 1400 triggers the communication apparatus 1400 to enable the second link. Further, after exchanging information with the sending device, the communication apparatus 1400 enters the connected state, and then receives the data over the second link.

For example, as shown in FIG. 13, the communication apparatus 1400 includes a frequency-amplitude converter 1410, configured to obtain second amplitude information of a fifth signal in a first linear working interval, where the fifth signal is a signal obtained by performing frequency mixing on the second signal and a first local oscillator signal. In other words, the fifth signal obtained by performing frequency mixing on the second signal and the first local oscillator signal is input to the frequency-amplitude converter 1410, and the frequency-amplitude converter 1410 may obtain the second amplitude information of the fifth signal.

In addition, the frequency-amplitude converter 1410 is further configured to demodulate a sixth signal in a second linear working interval. The sixth signal is a signal obtained by performing frequency mixing on the second signal and a second local oscillator signal, the second local oscillator signal is a signal obtained by performing frequency offset correction on the first local oscillator signal based on the second amplitude information, and the second linear working interval is smaller than the first linear working interval.

It should be noted that, when the communication apparatus 1400 is in the non-connected state, the frequency-amplitude converter 1410 of the communication apparatus 1400 uses the first linear working interval by default.

As described above, the communication apparatus 1400 first obtains, by using the frequency-amplitude converter 1410 that uses the first linear working interval, the second amplitude information of the fifth signal obtained by performing frequency mixing on the second signal and the first local oscillator signal. Then, the communication apparatus 1400 demodulates, by using the frequency-amplitude converter 1410 that uses the second linear working interval, the sixth signal obtained by performing frequency mixing on the second local oscillator signal and the second signal, where the second local oscillator signal is the signal obtained by performing frequency offset correction on the first local oscillator signal based on the second amplitude information. Because the first local oscillator signal has a frequency offset, the first linear working interval corresponding to the frequency-amplitude converter 1410 is set to be larger than the second linear working interval, so that a frequency of the fifth signal obtained by performing frequency mixing on the second signal and the first local oscillator signal does not exceed the second linear working interval corresponding to the frequency-amplitude converter 1410. Therefore, the frequency-amplitude converter 1410 can accurately obtain the second amplitude information of the fifth signal, to subsequently perform accurate frequency offset correction on the first local oscillator signal based on the second amplitude information.

Further, the communication apparatus 1400 demodulates, by using the frequency-amplitude converter 1410 that uses the second linear working interval, the sixth signal obtained by performing frequency mixing on the second local oscillator signal and the second signal. Because the second local oscillator signal is the signal obtained by performing frequency offset correction on the first local oscillator signal, a frequency offset value of the sixth signal is less than a frequency offset value of the signal obtained by performing frequency mixing on the first local oscillator signal and the second signal. In this way, even if the second linear working interval corresponding to the frequency-amplitude converter 1410 is set to be smaller (relative to the first linear working interval), the sixth signal can still be accurately demodulated. Therefore, demodulation performance of the communication apparatus 1400 is not severely affected.

Optionally, in an example, as shown in FIG. 14, the frequency-amplitude converter 1410 includes a first capacitor 1411, an RLC resonator 1412, and a multiplier 1413. A signal $S(t)$ input to the frequency-amplitude converter 1410 is divided into two channels. One channel of the signal directly enters the multiplier 1413. The other channel of the signal enters the first capacitor 1411, and is converged with a signal generated by the RLC resonator 1412 to form a signal $Sp(t)$. Then, the signal $Sp(t)$ enters the multiplier 1413 for frequency mixing with the signal $S(t)$, to obtain a signal $S(t)Sp(t)$ on which frequency mixing is performed. Another end of the RLC resonator 1412 is grounded.

Optionally, in an example, as shown in FIG. 15, the RLC resonator 1412 includes a second capacitor 14121, an inductor 14122, and a variable resistor 14123 that are connected in parallel. A frequency $f_c$ of a resonant signal generated by the RLC resonator 1412 satisfies the following:

$$f_c = \frac{2\pi}{\sqrt{LC}}$$

L is an inductance value of the inductor 14122, C is a capacitance value of the second capacitor 14121, and $f_c$ is also a frequency of the signal $S(t)$.

After the signal $S(t)$ passes through a phase shifting module, the signal $Sp(t)$ is obtained. Then, the signal $Sp(t)$ enters the multiplier for frequency mixing with the signal $S(t)$, to obtain the signal $S(t)Sp(t)$ on which frequency mixing is performed.

A phase $\phi_{rot}(f)$ that is of the signal $S(t)$ and that is rotated by the frequency-amplitude converter 1410 satisfies the following formula:

$$\phi_{rot}(f) = -\frac{\pi}{2} - 2\pi f_c RC \left(\frac{f - f_c}{f_c}\right)$$

R is a resistance value of the variable resistor 14123, and $-2\pi f_c RC$ is a slope of a frequency-amplitude conversion curve corresponding to the frequency-amplitude converter 1410. It can be seen that the slope of the frequency-amplitude conversion curve is in a negative linear correlation with the resistance value R of the variable resistor 14123. Therefore, the slope of the frequency-amplitude conversion curve may be adjusted by adjusting the resistance value R of the variable resistor 14123.

It can be learned from the foregoing descriptions in Embodiment 1 that the linear working interval corresponding to the frequency-amplitude converter 1410 is related to the slope of the frequency-amplitude conversion curve, and a larger slope of the frequency-amplitude conversion curve indicates a smaller linear working interval corresponding to the frequency-amplitude converter 1410. Therefore, if the first linear working interval needs to be adjusted to the second linear working interval smaller than the first linear working interval, the slope of the frequency-amplitude conversion curve of the frequency-amplitude converter 1410 may be increased. Further, because the slope of the frequency-amplitude conversion curve is in the negative linear correlation with the resistance value R of the variable resistor 14123, the resistance value of the resistor R in the frequency-amplitude converter 1410 may be increased, to achieve an objective of increasing the slope of the frequency-amplitude conversion curve of the frequency-amplitude converter 1410.

Optionally, in an example, as shown in FIG. 16, the communication apparatus 1400 further includes a frequency offset estimation module 1420. The frequency-amplitude converter 1410 is further configured to send the second amplitude information to the frequency offset estimation module 1420. The frequency offset estimation module 1420 is configured to obtain a second frequency offset value based on the second amplitude information. The frequency offset estimation module 1420 is further configured to send a control signal to the frequency offset estimation module 1420 if the second frequency offset value is less than a preset frequency offset value, where the control signal indicates the frequency-amplitude converter 1410 to reduce the linear working interval corresponding to the frequency-amplitude converter 1410. The frequency-amplitude converter 1410 is further configured to adjust the linear working interval corresponding to the frequency-amplitude converter 1410 from the first linear working interval to the second linear working interval.

A specific value of the preset frequency offset value is not limited in this embodiment of this application, and may be determined based on an actual situation.

In an example, the frequency offset estimation module 1420 may obtain the second frequency offset value based on the second amplitude information and second ideal amplitude information.

The second ideal amplitude information may be understood as amplitude information corresponding to the fifth signal obtained by performing frequency mixing on the second signal and the first local oscillator signal, when the first local oscillator signal has no frequency offset.

It should be noted that the second ideal amplitude information may be sent by the sending device to the communication apparatus 1400. Alternatively, the second ideal amplitude information may be calculated by a receiving device based on a sending frequency of the second signal and a slope of a first frequency-amplitude conversion curve.

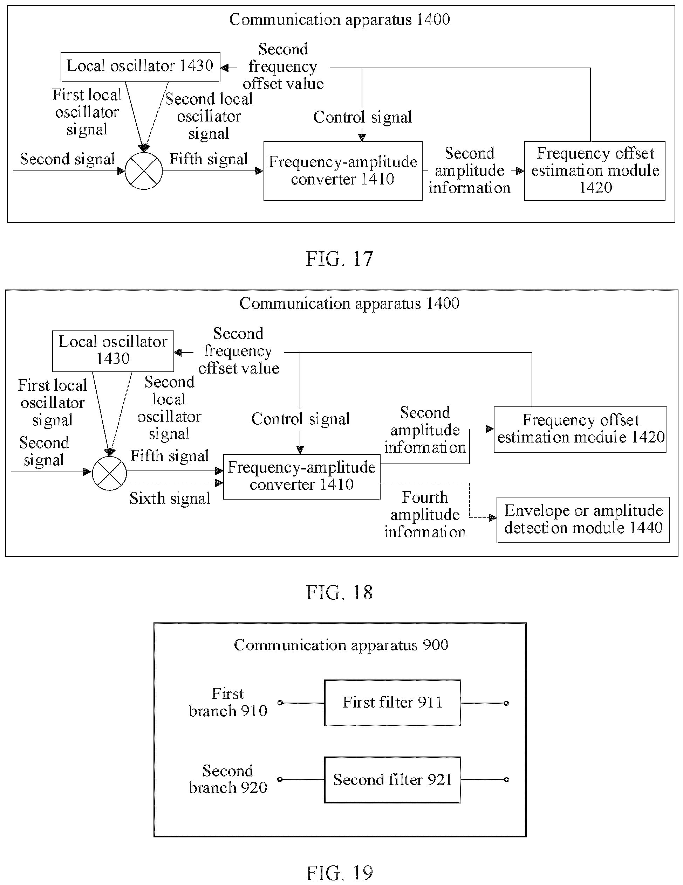

Optionally, in an example, as shown in FIG. 17, the communication apparatus 1400 further includes a local oscillator 1430. The frequency offset estimation module 1420 is further configured to send the second frequency offset value to the local oscillator 1430. The local oscillator 1430 is configured to perform frequency offset correction on the first local oscillator signal based on the second frequency offset value, to obtain the second local oscillator signal.

Optionally, in an example, as shown in FIG. 18, the communication apparatus 1400 further includes an envelope or amplitude detection module 1440. The frequency-amplitude converter 1410 is further specifically configured to: obtain fourth amplitude information of the sixth signal in the second linear working interval, and send the fourth amplitude information to the envelope or amplitude detection module 1440. The envelope or amplitude detection module 1440 is configured to obtain modulation information of the sixth signal based on the fourth amplitude information.

How the envelope or amplitude detection module 1440 obtains the modulation information of the sixth signal based on the fourth amplitude information is not limited in this embodiment of this application.

In an example, if the sending device performs frequency shift keying modulation on the second signal, the envelope or amplitude detection module 1440 obtains, based on the second amplitude information of the fifth signal, the modulation information carried in the sixth signal.

In another example, if the sending device performs differential frequency modulation on the second signal, in other words, a differential frequency modulation scheme is used for the second signal, the envelope or amplitude detection module 1440 first obtains, based on the second amplitude information of the fifth signal, a frequency difference of the fifth signal transmitted in adjacent time units, where a frequency of the fifth signal transmitted in a $k^{th}$ time unit is $f(k) = \text{mod}[f(k-1) + \Delta f_1(k), B4]$, $\Delta f_1(k)$ is a difference between a frequency of a $k^{th}$ fifth signal and a frequency of a $(k-1)^{th}$ fifth signal in a sequence of the fifth signal, B4 is a preset fourth bandwidth value, and $k$ is an integer greater than 1; and then obtains, based on the frequency difference of the fifth signal, modulation information carried in the fifth signal.

It should be noted that when *k* is 2, *f(k-1)=f(1)* may be any value. A specific value of *f(1)* is not limited in this embodiment of this application.

Because a time interval between two consecutive time units is extremely short, even if a residual frequency offset exists in the local oscillator signal generated by the communication apparatus, residual frequency offsets of local oscillator signals generated in the two consecutive time units by the communication apparatus may be considered to be the same. In this way, the residual frequency offset of the local oscillator signal generated by the communication apparatus may be canceled by subtracting between frequencies of fifth signals in the two consecutive time units (that is, the differential frequency modulation scheme). Therefore, the demodulation performance of the communication apparatus 1400 is not further affected.

For an example of this example, refer to the related example in Embodiment 1. Details are not described herein again.

In addition, in the non-coherent FSK receiving device shown in FIG. 4, the BPF is also a key module, and may filter signals of different frequency bands. However, as described above, the offset usually exists between the ideal frequency and the frequency of the local oscillator signal generated by the LO. In this case, an offset Δ*f* exists between the ideal frequency and a frequency of a signal obtained by performing frequency mixing on a received signal and the local oscillator signal generated by the LO. If the offset Δ*f* is large, the frequency of the signal obtained by performing frequency mixing on the received signal and the local oscillator signal generated by the LO exceeds or partially exceeds a bandwidth of the BPF. In this way, the BPF filters out or partially filters out the signal obtained by performing frequency mixing on the local oscillator signal and the received signal. As a result, the receiving device cannot demodulate a signal sent by the sending device.

Therefore, an embodiment of this application further provides another communication apparatus. The communication apparatus may perform frequency offset correction on a local oscillator signal. In addition, in a process of performing frequency offset correction on the local oscillator signal, a filter does not filter out a signal obtained by performing frequency mixing on the local oscillator signal and a received signal. In this way, the communication apparatus can receive a signal sent by a sending device, and can reduce an error of a baseband signal obtained by demodulating the received signal. This improves demodulation performance of a receiving device.

A type of the communication apparatus in this embodiment is not limited in this application. For example, the communication apparatus may be any device shown in FIG. 1, or the communication apparatus may be an apparatus in any device shown in FIG. 1.

For example, the communication apparatus also includes two branches. One branch filters a signal obtained by performing frequency mixing on a local oscillator signal before the correction and the received signal, and the other branch filters a signal obtained by performing frequency mixing on a local oscillator signal after the correction and the received signal.

The two branches may work in a time division manner, or may work simultaneously. For ease of description, that the two branches work in the time division manner is denoted as Embodiment 4, and that the two branches work simultaneously is denoted as Embodiment 5.

For an example of how to implement time division working of the two branches, refer to the foregoing related descriptions. Details are not described herein again.

The following describes the communication apparatus in detail by using Embodiment 4 and Embodiment 5 as examples.

## Embodiment 4

FIG. 19 is a diagram of a structure of another communication apparatus according to an embodiment of this application.

The communication apparatus 900 shown in FIG. 19 is configured to receive a first signal and a second signal, where both the second signal and the first signal are from a same device (which may be referred to as a sending device), and the second signal indicates the communication apparatus to enter a connected state.

For descriptions of that the communication apparatus 900 is configured to receive the first signal and the second signal, refer to the related descriptions of that the communication apparatus 800 is configured to receive the first signal and the second signal in Embodiment 1. Details are not described herein again.

For example, as shown in FIG. 19, the communication apparatus 900 includes a first branch 910 and a second branch 920.

The first branch 910 includes a first filter 911. The first filter 911 is configured to filter a third signal, where the third signal is a signal obtained by performing frequency mixing on the first signal and a first local oscillator signal.

The second branch 920 includes a second filter 921. The second filter 921 is configured to filter a fourth signal, where the fourth signal is a signal obtained by performing frequency mixing on the second signal and a second local oscillator signal, the second local oscillator signal is a signal obtained by performing frequency offset correction on the first local oscillator signal based on first amplitude information of the third signal, and a bandwidth of the second filter is less than a bandwidth of the first filter.

It should be noted that a type of the first filter 911 and/or a type of the second filter 921 are/is not limited in this embodiment of this application. For example, the first filter 911 and/or the second filter 921 may be a band-pass filter or a low-pass filter.

As described above, the communication apparatus 900 first filters, by using the first filter 911 on the first branch 910, the third signal obtained by performing frequency mixing on the first signal and the first local oscillator signal. Then, the communication apparatus 900 filters, by using the second filter 921 on the second branch 920, the fourth signal obtained by performing frequency mixing on the second signal and the second local oscillator signal, where the second local oscillator signal is the signal obtained by performing frequency offset correction on the first local oscillator signal based on the first amplitude information of the third signal. Because the first local oscillator signal has a frequency offset, the bandwidth of the first filter 911 on the first branch 910 is set to be greater than the bandwidth of the second filter 921, so that the first filter 911 still does not filter out the third signal even if the first local oscillator signal has the frequency offset. In this way, the frequency offset correction may be performed subsequently on the first local oscillator signal based on the third signal.

Further, the communication apparatus 900 filters, by using the second filter 921 on the second branch 920, the fourth signal obtained by performing frequency mixing on the second signal and the second local oscillator signal. Because the second local oscillator signal is the signal obtained by performing frequency offset correction on the first local oscillator signal, a frequency offset value of the fourth signal is less than a frequency offset value of a signal obtained by performing frequency mixing on the first local oscillator signal and the second signal. In this way, the bandwidth of the second filter 921 on the second branch 920 is set to a small bandwidth (relative to the bandwidth of the first filter 911), to ensure that the second filter 921 does not filter out the fourth signal even if a residual frequency offset exists, and the second filter 921 can filter out out-of-band noise because a passband is narrow. This reduces a noise level of the communication apparatus 900, to improve performance of demodulating the fourth signal by the communication apparatus 900.

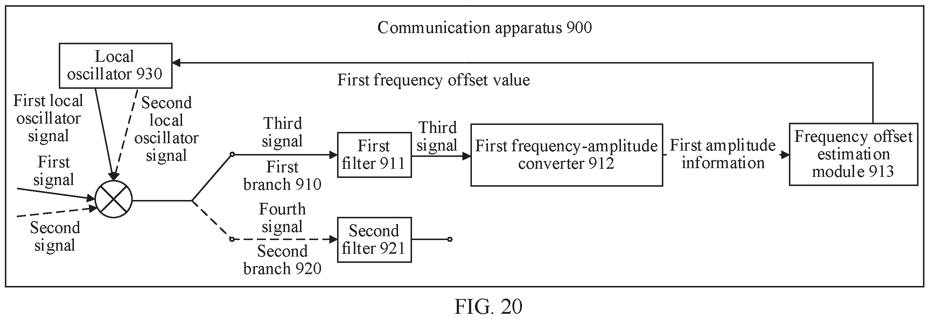

Optionally, in an example, as shown in FIG. 20, the first branch 910 of the communication apparatus 900 further includes a first frequency-amplitude converter 912. The first frequency-amplitude converter 912 is configured to obtain the first amplitude information of the third signal. In addition, the communication apparatus 900 further includes a frequency offset estimation module 913 and a local oscillator 930. The first frequency-amplitude converter 912 is further configured to send the first amplitude information to the frequency offset estimation module 913. The frequency offset estimation module 913 is configured to: obtain a first frequency offset value based on the first amplitude information, and send the first frequency offset value to the local oscillator 930. The local oscillator 930 is configured to perform frequency offset correction on the first local oscillator signal based on the first frequency offset value, to obtain the second local oscillator signal.

It should be noted that the third signal in that the first frequency-amplitude converter 912 is configured to obtain the first amplitude information of the third signal is a third signal obtained by filtering the third signal by the first filter 911.

Optionally, in an example, an internal structure of the first frequency-amplitude converter 911 is the same as an internal structure of the first frequency-amplitude converter 811 described in Embodiment 1. For a part of the first frequency-amplitude converter 911 that is not described, refer to the related descriptions of the first frequency-amplitude converter 811. Details are not described herein again.

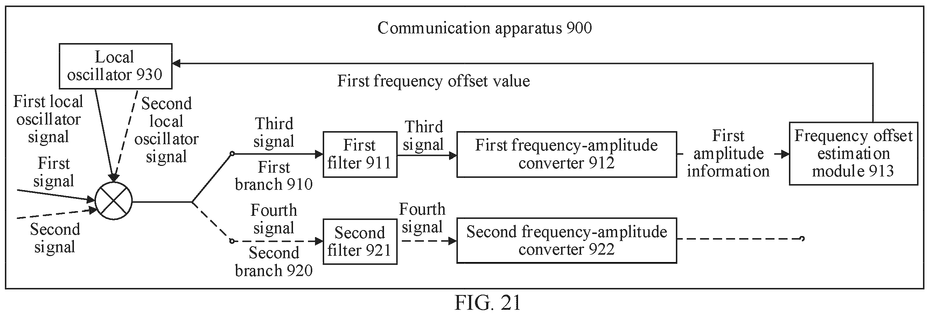

Optionally, in an example, as shown in FIG. 21, the second branch 920 of the communication apparatus 900 further includes a second frequency-amplitude converter 922, configured to demodulate a filtered fourth signal. A linear working interval corresponding to the second frequency-amplitude converter 922 is smaller than a linear working interval corresponding to the first frequency-amplitude converter 912.

Optionally, in an example, an internal structure of the second frequency-amplitude converter 922 is the same as an internal structure of the second frequency-amplitude converter 821 in Embodiment 1. For a part of the second frequency-amplitude converter 922 that is not described, refer to the related descriptions of the second frequency-amplitude converter 821. Details are not described herein again.

For a reason why the linear working interval corresponding to the second frequency-amplitude converter 922 is set to be smaller than the linear working interval corresponding to the first frequency-amplitude converter 912, how to set the linear working interval corresponding to the second frequency-amplitude converter 922 to be smaller than the linear working interval corresponding to the first frequency-amplitude converter 912, and technical effects brought by setting the linear working interval corresponding to the second frequency-amplitude converter 922 to be smaller than the linear working interval corresponding to the first frequency-amplitude converter 912, refer to a reason why a linear working interval corresponding to the second frequency-amplitude converter 821 is set to be smaller than a linear working interval corresponding to the first frequency-amplitude converter 821, how to set the linear working interval corresponding to the second frequency-amplitude converter 821 to be smaller than the linear working interval corresponding to the first frequency-amplitude converter 821, and technical effects brought by setting the linear working interval corresponding to the second frequency-amplitude converter 821 to be smaller than the linear working interval corresponding to the first frequency-amplitude converter 821. Details are not described herein again.

Optionally, in an example, the second branch 920 is configured to demodulate the fourth signal. For a process in which the fourth signal is demodulated by the second branch 920, refer to the related descriptions of the demodulating the fourth signal by the second branch 820 in Embodiment 1. Details are not described herein again.

**Embodiment 5**

It can be learned from the foregoing descriptions of Embodiment 4 that, in Embodiment 4, the communication apparatus 900 uses the first branch 810 to filter the fifth signal obtained by performing frequency mixing on the received first signal and the first local oscillator signal, where the fifth signal is used to perform frequency offset correction on the first local oscillator signal. Then, the communication apparatus 900 filters, through the second branch 920, the sixth signal obtained by performing frequency mixing on the received second signal and the second local oscillator signal. In other words, the sending device needs to send two signals (the first signal and the second signal), and the communication apparatus 900 filters the two received signals through two branches (the first branch 910 and the second branch 920) in a time division manner based on the two received signals.

Further, to reduce signaling overheads of the sending device, the sending device may alternatively send only one signal (the second signal). In this way, the communication apparatus 900 filters the two received signals through the two branches (the first branch 910 and the second branch 920) based on the received signal. A filtered signal in one branch may be used to perform frequency offset correction on the first local oscillator signal. In this case, this solution is referred to as Embodiment 5.

In comparison with Embodiment 4, Embodiment 5 has the following differences:

1. The communication apparatus 900 is configured to receive only the second signal.
2. The first filter 911 on the first branch 910 of the communication apparatus 900 is configured to filter a fifth signal, where the fifth signal is a signal obtained by performing frequency mixing on the second signal and the first local oscillator signal.
3. The second filter 921 on the second branch 920 of the communication apparatus 900 is configured to filter a sixth signal, where the sixth signal is a signal obtained by performing frequency mixing on the second signal and the second local oscillator signal, and the second local oscillator signal is the signal obtained by performing frequency offset correction on the first local oscillator signal based on second amplitude information of the fifth signal.

In this way, the related descriptions in Embodiment 4 are replaced with the following four points: (1) That the communication apparatus 900 is configured to receive the first signal and the second signal is replaced with that the communication apparatus 900 is configured to receive the second signal. (2) The third signal is replaced with the fifth signal. (3) The first amplitude information is replaced with the second amplitude information, and the first frequency offset value is replaced with a second frequency offset value. (4) The fourth signal is replaced with the sixth signal. In this way, related descriptions in Embodiment 5 may be obtained. Therefore, details are not described herein again.

**Embodiment 6**

It can be learned from the foregoing descriptions of Embodiment 4 and Embodiment 5 that two branches need to be disposed in the communication apparatus 900, and a filter needs to be disposed on each branch, so that one branch can filter a signal obtained by performing frequency mixing on a received signal and a local oscillator signal generated by the communication apparatus 900, and the other branch can filter a signal obtained by performing frequency mixing on a received signal and a signal obtained by performing frequency offset correction on the local oscillator signal generated by the communication apparatus 900.

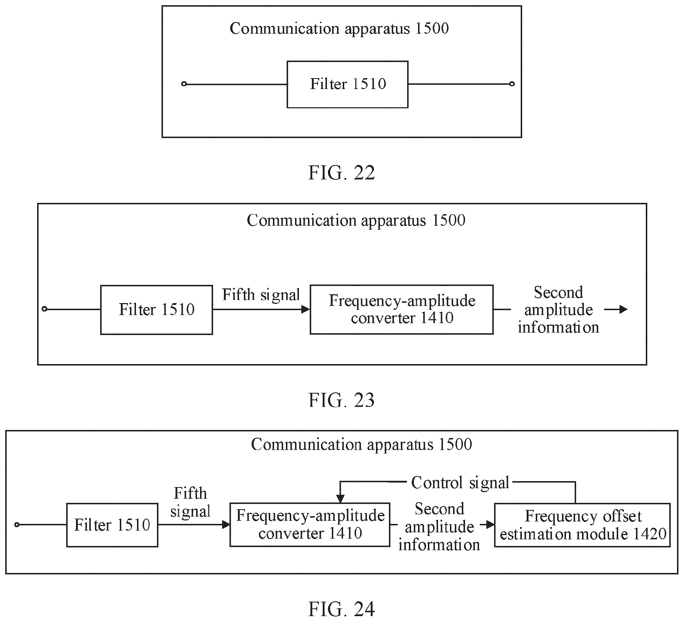

Further, to reduce complexity and costs of a system of the communication apparatus 900, an embodiment of this application further provides another communication apparatus. Only one line needs to be disposed in the communication apparatus, and one filter whose bandwidth can be adjusted based on a frequency offset of the local oscillator signal generated by the communication apparatus is disposed on the line. In this way, the communication apparatus needs only one path and one filter, to implement filtering of a signal obtained by performing frequency mixing on a local oscillator signal before the correction and the received signal, and implement filtering of a signal obtained by performing frequency mixing on the local oscillator signal after the correction and the received signal. The following describes the communication apparatus with reference to FIG. 22 to FIG. 26.

FIG. 22 is a diagram of a structure of another communication apparatus 1500 according to an embodiment of this application.

A type of the communication apparatus 1500 in this embodiment is not limited in this application. For example, the communication apparatus 1500 may be any device shown in FIG. 1, or the communication apparatus 1500 may be an apparatus in any device shown in FIG. 1.

The communication apparatus 1500 shown in FIG. 22 is configured to receive a second signal, where the second signal indicates the communication apparatus to enter a connected state.

For descriptions of that the communication apparatus 1500 is configured to receive the second signal, refer to the related descriptions of that the communication apparatus 1400 is configured to receive the second signal. Details are not described herein again.

For example, as shown in FIG. 22, the communication apparatus 1500 includes a filter 1510, configured to filter a fifth signal based on a first bandwidth, where the fifth signal is a signal obtained by performing frequency mixing on the second signal and a first local oscillator signal.

In addition, the filter 1510 is configured to filter a sixth signal based on a second bandwidth, where the sixth signal is a signal obtained by performing frequency mixing on the second signal and a second local oscillator signal, the second local oscillator signal is a signal obtained by performing frequency offset correction on the first local oscillator signal based on second amplitude information of the fifth signal, and the second bandwidth is less than the first bandwidth.

It should be noted that a type of the filter 1510 is not limited in this embodiment of this application. For example, the filter 1510 may be a band-pass filter or a low-pass filter.

In addition, when the communication apparatus 1500 is in a non-connected state, the filter 1510 of the communication apparatus 1500 uses the first bandwidth by default.

As described above, the filter 1510 of the communication apparatus 1510 filters, based on the first bandwidth, the fifth signal obtained by performing frequency mixing on the second signal and the first local oscillator signal. Then, the filter 1510 filters, based on the second bandwidth, the sixth signal obtained by performing frequency mixing on the second signal and the second local oscillator signal, where the second local oscillator signal is the signal obtained by performing frequency offset correction on the first local oscillator signal based on the second amplitude information of the fifth signal. Because the first local oscillator signal has a frequency offset, a bandwidth of the filter 1510 is set to be greater than the second bandwidth, so that the filter 1510 still does not filter out the fifth signal even if the first local oscillator signal has the frequency offset. In this way, the frequency offset correction may be performed subsequently on the first local oscillator signal based on the fifth signal.

Further, the filter 1510 of the communication apparatus 1510 filters, based on the second bandwidth, the sixth signal obtained by performing frequency mixing on the second signal and the second local oscillator signal. Because the second local oscillator signal is the signal obtained by performing frequency offset correction on the first local oscillator signal, a frequency offset value of the sixth signal is less than a frequency offset value of the signal obtained by performing frequency mixing on the first local oscillator signal and the second signal. In this way, even if the bandwidth of the filter 1510 is set to a small bandwidth (relative to the first bandwidth), it is ensured that the filter 1510 does not filter out the sixth signal even if a residual frequency offset exists, and the filter 1510 can filter out out-of-band noise because a passband is narrow. This reduces a noise level of the communication apparatus 1500, to improve performance of demodulating the sixth signal by the communication apparatus 1500.

Optionally, in an example, as shown in FIG. 23, the communication apparatus 1510 further includes a frequency-amplitude converter 1410. A use of the frequency-amplitude converter 1410 is described in Embodiment 3. Details are not described herein again.

It should be noted that the fifth signal in that the frequency-amplitude converter 1410 is configured to obtain the second amplitude information of the fifth signal is a fifth signal obtained by filtering the fifth signal by the filter 1510 based on the first bandwidth. In addition, the sixth signal in that the frequency-amplitude converter 1410 is configured to demodulate the sixth signal is a sixth signal obtained by filtering the sixth signal by the filter 1510 based on the second bandwidth.

For other descriptions of the frequency-amplitude converter 1410, refer to the related descriptions in Embodiment 3. Details are not described herein again.

Optionally, in an example, as shown in FIG. 24, the communication apparatus 1500 further includes a frequency offset estimation module 1420. A use of the frequency offset estimation module 1420 is described in Embodiment 3. Details are not described herein again.

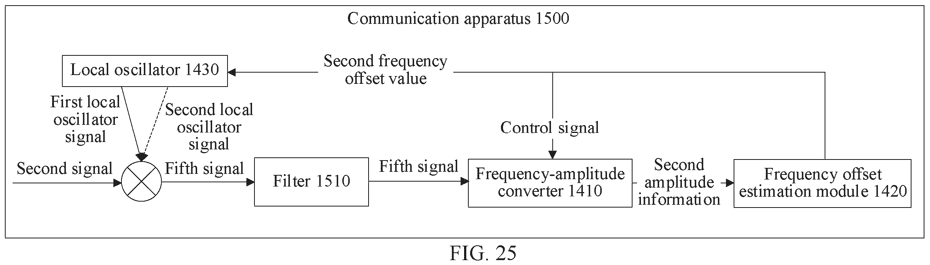

Optionally, in an example, as shown in FIG. 25, the communication apparatus 1500 further includes a local oscillator 1430. A use of the frequency offset estimation module 1430 is described in Embodiment 3. Details are not described herein again.

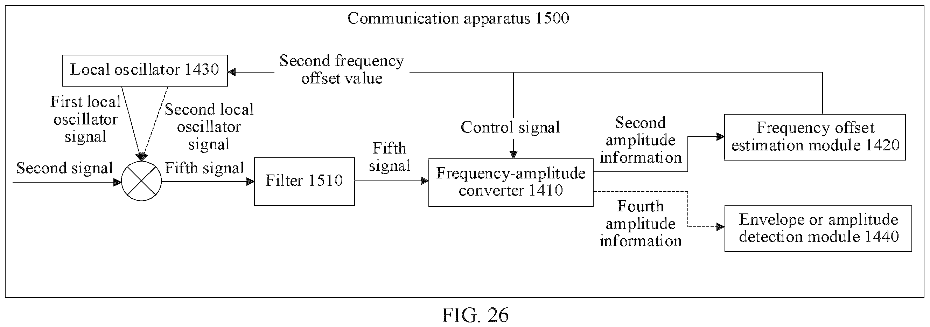

Optionally, in an example, as shown in FIG. 26, the communication apparatus 1500 further includes an envelope or amplitude detection module 1440. A use of the envelope or amplitude detection module 1440 is described in Embodiment 3. Details are not described herein again.

It should be noted that, in this embodiment of this application, the communication apparatus 800, the communication apparatus 1400, the communication apparatus 900, and/or the communication apparatus 1500 described above may further include another module that is not described. This is not limited in this application.

For example, the communication apparatus 800, the communication apparatus 1400, the communication apparatus 900, and/or the communication apparatus 1500 may further include another filter, an amplifier, and the like.

For example, the another filter may include an RF BPF and/or an LPF.

In the communication apparatus 800, the RF BPF is configured to filter a first signal and/or a second signal that are/is received by the communication apparatus 800 through an antenna, and the LPF is configured to filter amplitude information obtained by a first frequency-amplitude converter 811 and/or a second frequency-amplitude converter 821.

In the communication apparatus 1400 and/or the communication apparatus 1500, the RF BPF is configured to filter a second signal received by the communication apparatus 1400 and/or the communication apparatus 1500 through an antenna, and the LPF is configured to filter amplitude information obtained by the frequency-amplitude converter 1410.

In the communication apparatus 900, the RF BPF is configured to filter a second signal received by the communication apparatus 900 through an antenna, and the LPF is configured to filter amplitude information obtained by a first frequency-amplitude converter 912 and/or a second frequency-amplitude converter 922.

For example, the amplifier may include an RF LNA and an IF LNA.

In the communication apparatus 800, the RF LNA is configured to amplify a first signal and/or a second signal obtained by filtering by the RF BPF, and the IF LNA is configured to amplify a third signal and/or a fourth signal.

In the communication apparatus 1400, the communication apparatus 900, and/or the communication apparatus 1500, the RF LNA is configured to amplify a second signal obtained by filtering by the RF BPF, and the IF LNA is configured to amplify a fifth signal and/or a sixth signal.

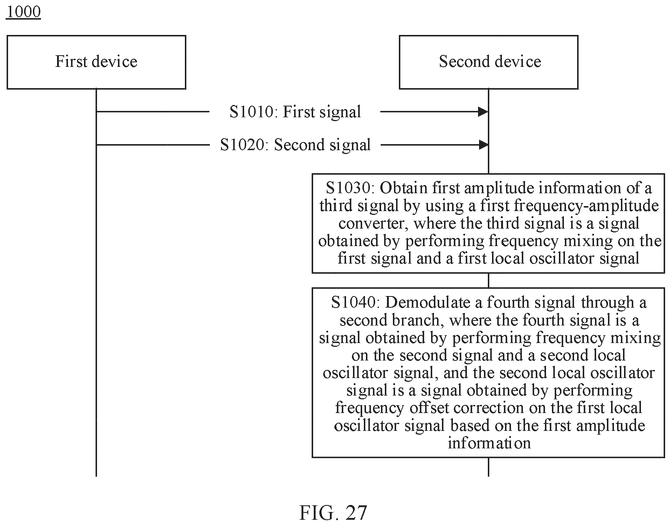

With reference to FIG. 27 to FIG. 32, the following describes in detail the communication method provided in embodiments of this application.

The communication method may be applied to a communication system including a first device and a second device. In an example, the first device may be the base station or the satellite site in FIG. 1, and the second device may be the terminal device in FIG. 1.

In another example, the first device may be the terminal device in FIG. 1, and the second device may be the another terminal device in FIG. 1.

In still another example, the first device may be the sending device described in the foregoing related descriptions about the communication apparatus 800, the communication apparatus 1400, the communication apparatus 900, or the communication apparatus 1500, and the second device may be the communication apparatus 800, the communication apparatus 1400, the communication apparatus 900, or the communication apparatus 1500.

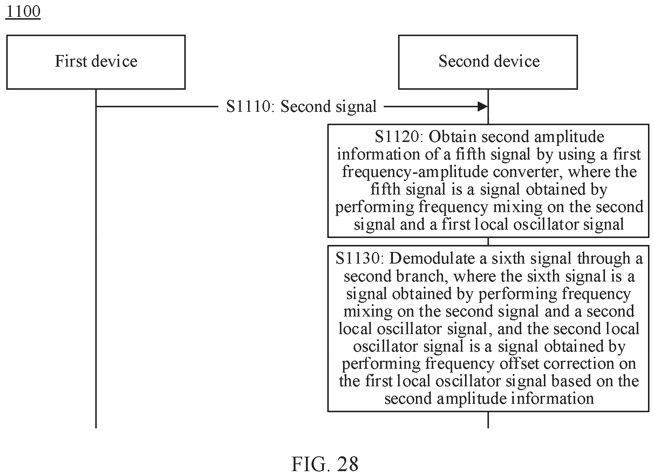

In an implementation, the second device includes a first branch and a second branch, the first branch includes a first frequency-amplitude converter, the second branch includes a second frequency-amplitude converter, and a linear working interval corresponding to the second frequency-amplitude converter is smaller than a linear working interval corresponding to the first frequency-amplitude converter. With reference to FIG. 27 and FIG. 28, the following describes the communication method in this implementation.

FIG. 27 is a schematic flowchart of a communication method 1000 according to an embodiment of this application.

For example, as shown in FIG. 27, the communication method 1000 includes S1010 to S1030. The following separately describes S1010 to S1030 in detail.

S1010: A first device sends a first signal to a second device. Correspondingly, the second device receives the first signal sent by the first device.

S1020: The first device sends a second signal to the second device. Correspondingly, the second device receives the second signal sent by the first device.

S1030: The second device obtains first amplitude information of a third signal by using a first frequency-amplitude converter, where the third signal is a signal obtained by performing frequency mixing on the first signal and a first local oscillator signal.

S1040: The second device demodulates a fourth signal through a second branch, where the fourth signal is a signal obtained by performing frequency mixing on the second signal and a second local oscillator signal, and the second local oscillator signal is a signal obtained by performing frequency offset correction on the first local oscillator signal based on the first amplitude information.

For a part of the communication method 1000 that is not described, refer to the related descriptions in Embodiment 1. Details are not described herein again.

FIG. 28 is a schematic flowchart of a communication method 1100 according to an embodiment of this application.

For example, as shown in FIG. 28, the communication method 1100 includes S1110 to S1130. The following separately describes S1110 to S1130 in detail.

S1110: A first device sends a second signal to a second device. Correspondingly, the second device receives the second signal sent by the first device.

S1120: The second device obtains second amplitude information of a fifth signal by using a first frequency-amplitude converter, where the fifth signal is a signal obtained by performing frequency mixing on the second signal and a first local oscillator signal.

S1130: The second device demodulates a sixth signal through a second branch, where the sixth signal is a signal obtained by performing frequency mixing on the second signal and a second local oscillator signal, and the second local oscillator signal is a signal obtained by performing frequency offset correction on the first local oscillator signal based on the second amplitude information.

For a part of the communication method 1100 that is not described, refer to the related descriptions in Embodiment 2. Details are not described herein again.

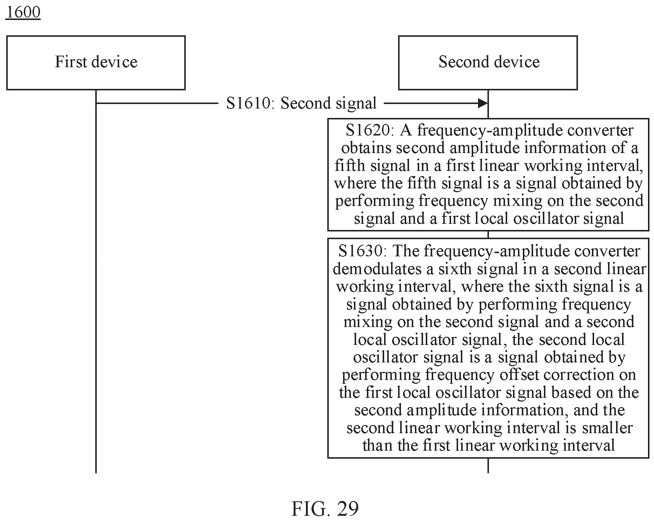

In another possible implementation, the second device includes a line, the line includes a frequency-amplitude converter, and a linear working interval corresponding to the frequency-amplitude converter may be adjusted with a frequency offset of a local oscillator signal generated by the second device. With reference to FIG. 29, the following describes the communication method in this implementation.

FIG. 29 is a schematic flowchart of a communication method 1600 according to an embodiment of this application.

For example, as shown in FIG. 29, the communication method 1600 includes S1610 to S1630. The following separately describes S1610 to S1630 in detail.

S1610: A first device sends a second signal to a second device. Correspondingly, the second device receives the second signal sent by the first device.

S1620: A frequency-amplitude converter of the second device obtains second amplitude information of a fifth signal in a first linear working interval, where the fifth signal is a signal obtained by performing frequency mixing on the second signal and a first local oscillator signal.

S1630: The frequency-amplitude converter of the second device demodulates a sixth signal in a second linear working interval, where the sixth signal is a signal obtained by performing frequency mixing on the second signal and a second local oscillator signal, the second local oscillator signal is a signal obtained by performing frequency offset correction on the first local oscillator signal based on the second amplitude information, and the second linear working interval is smaller than the first linear working interval.

For a part of the communication method 1600 that is not described, refer to the related descriptions in Embodiment 3. Details are not described herein again.

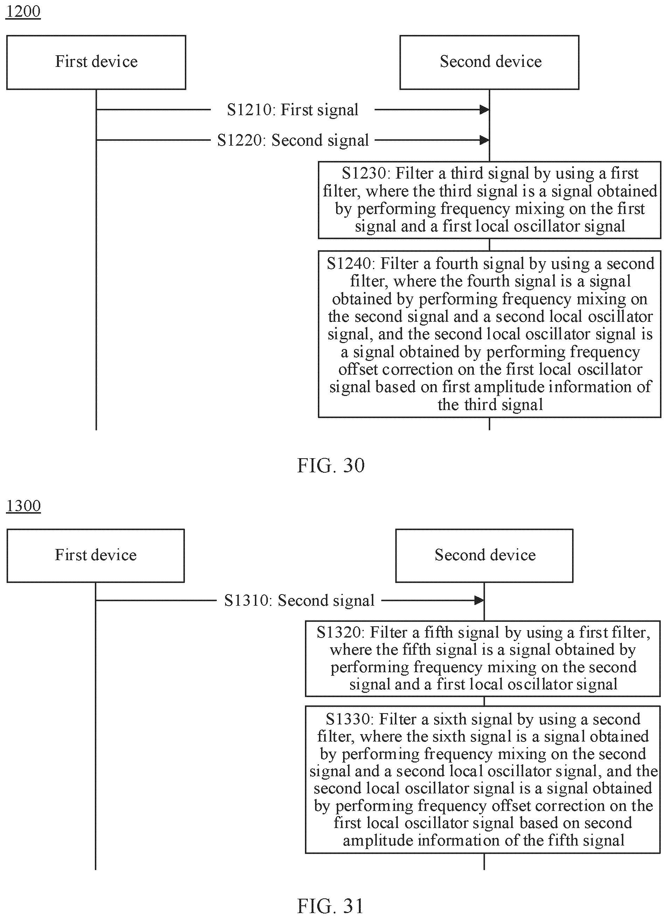

In still another possible implementation, the second device includes a first branch and a second branch, the first branch includes a first filter, the second branch includes a second filter, and a bandwidth of the second filter is less than a bandwidth of the first filter. With reference to FIG. 30 and FIG. 31, the following describes the communication method in this implementation.

FIG. 30 is a schematic flowchart of a communication method 1200 according to an embodiment of this application.

For example, as shown in FIG. 30, the communication method 1200 includes S1210 to S1240. The following separately describes S1210 to S1230 in detail.

S1210: A first device sends a first signal to a second device. Correspondingly, the second device receives the first signal sent by the first device.

S1220: The first device sends a second signal to the second device. Correspondingly, the second device receives the second signal sent by the first device.

S1230: The second device filters a third signal by using a first filter, where the third signal is a signal obtained by performing frequency mixing on the first signal and a first local oscillator signal.

S1240: The second device filters a fourth signal by using a second filter, where the fourth signal is a signal obtained by performing frequency mixing on the second signal and a second local oscillator signal, and the second local oscillator signal is a signal obtained by performing frequency offset correction on the first local oscillator signal based on first amplitude information of the third signal.

For a part of the communication method 1200 that is not described, refer to the related descriptions in Embodiment 4. Details are not described herein again.

FIG. 31 is a schematic flowchart of a communication method 1300 according to an embodiment of this application.

For example, as shown in FIG. 31, the communication method 1300 includes S1310 to S1330. The following separately describes S1310 to S1330 in detail.

S1310: A first device sends a second signal to a second device. Correspondingly, the second device receives the second signal sent by the first device.

S1320: The second device filters a fifth signal by using a first filter, where the fifth signal is a signal obtained by performing frequency mixing on the second signal and a first local oscillator signal.

S1330: The second device filters a sixth signal by using a second filter, where the sixth signal is a signal obtained by performing frequency mixing on the second signal and a second local oscillator signal, and the second local oscillator signal is a signal obtained by performing frequency offset correction on the first local oscillator signal based on second amplitude information of the fifth signal.

For a part of the communication method 1200 that is not described, refer to the related descriptions in Embodiment 5. Details are not described herein again.

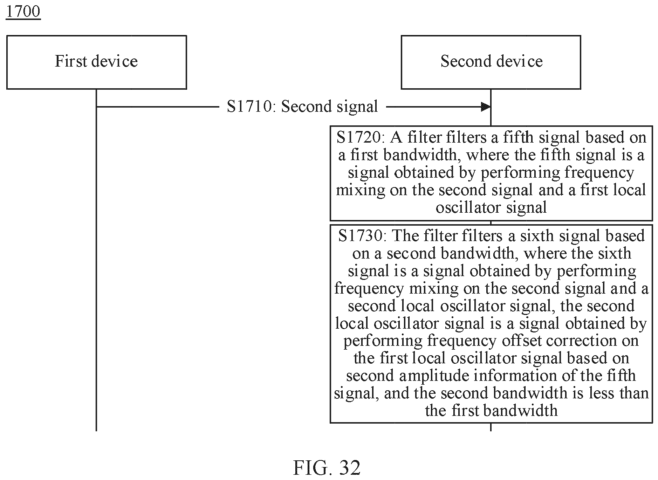

In still another possible implementation, the second device includes a line, the line includes a filter, and a bandwidth of the filter may be adjusted with a frequency offset of a local oscillator signal generated by the second device. With reference to FIG. 32, the following describes the communication method in this implementation.

FIG. 32 is a schematic flowchart of a communication method 1700 according to an embodiment of this application.

For example, as shown in FIG. 32, the communication method 1700 includes S1710 to S1730. The following separately describes S1710 to S1730 in detail.

S1710: A first device sends a second signal to a second device. Correspondingly, the second device receives the second signal sent by the first device.

S 1720: A filter of the second device filters a fifth signal based on a first bandwidth, where the fifth signal is a signal obtained by performing frequency mixing on the second signal and a first local oscillator signal.

S 1730: The filter of the second device filters a sixth signal based on a second bandwidth, where the sixth signal is a signal obtained by performing frequency mixing on the second signal and a second local oscillator signal, the second local oscillator signal is a signal obtained by performing frequency offset correction on the first local oscillator signal based on second amplitude information of the fifth signal, and the second bandwidth is less than the first bandwidth.

For a part of the communication method 1700 that is not described, refer to the related descriptions in Embodiment 6. Details are not described herein again.

An embodiment of this application provides a communication system, including a first device and a second device. The system is configured to perform the technical solutions of the foregoing embodiments. Implementation principles and technical effects thereof are similar to those of the foregoing method-related embodiments. Details are not described herein again.

An embodiment of this application provides a computer program product. When the computer program product runs on a device, the device is enabled to perform the technical solutions of the foregoing embodiments. Implementation principles and technical effects thereof are similar to those of the foregoing method-related embodiments. Details are not described herein again. The device may include the first device or the second device described in the foregoing embodiments.

An embodiment of this application provides a readable storage medium. The readable storage medium includes instructions. When the instructions are run on a device, the device is enabled to perform the technical solutions of the foregoing embodiments. Implementation principles and technical effects thereof are similar. Details are not described herein again. The device may include the first device or the second device described in the foregoing embodiments.

An embodiment of this application provides a chip. The chip is configured to execute instructions. When the chip runs, the technical solutions of the foregoing embodiments are performed. Implementation principles and technical effects thereof are similar. Details are not described herein again.

A person of ordinary skill in the art may be aware that, in combination with the examples described in embodiments disclosed in this specification, units and algorithm steps can be implemented by electronic hardware or a combination of computer software and electronic hardware. Whether the functions are performed by hardware or software depends on particular applications and design constraints of the technical solutions. A person skilled in the art may use different methods to implement the described functions for each particular application, but it should not be considered that the implementation goes beyond the scope of embodiments of this application.

It may be clearly understood by a person skilled in the art that, for a purpose of convenient and brief description, for a detailed working process of the foregoing system, apparatus, and unit, refer to a corresponding process in the foregoing method embodiments. Details are not described herein again.

In some embodiments provided in this application, it should be understood that the disclosed system, apparatus, and method may be implemented in another manner. For example, the described apparatus embodiments are merely examples. For example, division into the units is merely logical function division and may be other division in actual implementation. For example, a plurality of units or components may be combined or integrated into another system, or some features may be ignored or not performed. In addition, the displayed or discussed mutual couplings, direct couplings, or communication connections may be implemented through some interfaces. The indirect couplings or communication connections between the apparatuses or units may be implemented in electronic, mechanical, or another form.

The units described as separate parts may or may not be physically separate, and parts displayed as units may or may not be physical units, may be located in one position, or may be distributed on a plurality of network units. Some or all of the units may be selected based on an actual requirement to achieve the objectives of the solutions of embodiments.

In addition, function units in embodiments of this application may be integrated into one processing unit, each of the units may exist alone physically, or two or more units are integrated into one unit.

When the functions are implemented in a form of a software function unit and sold or used as an independent product, the functions may be stored in a computer-readable storage medium. Based on such an understanding, the technical solutions of embodiments of this application essentially, the part contributing to the conventional technology, or a part of the technical solutions may be implemented in a form of a software product. The computer software product is stored in a storage medium, and includes several instructions for instructing a computer device (which may be a personal computer, a server, a network device, or the like) to perform all or some of the steps of the methods described in embodiments of this application. The foregoing storage medium includes any medium that may store program code, such as a USB flash drive, a removable hard disk, a read-only memory (read-only memory, ROM), a random access memory (random access memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. A communication apparatus, wherein

   the communication apparatus is configured to receive a first signal and a second signal, wherein both the second signal and the first signal are from a same device, and the second signal indicates the communication apparatus to enter a connected state; and
   the communication apparatus comprises a first branch and a second branch, wherein
   the first branch comprises a first frequency-amplitude converter, configured to obtain first amplitude information of a third signal, wherein the third signal is a signal obtained by performing frequency mixing on the first signal and a first local oscillator signal, and the first local oscillator signal is a local oscillator signal generated by the communication apparatus; and
   the second branch is configured to demodulate a fourth signal, wherein the fourth signal is a signal obtained by performing frequency mixing on the second signal and a second local oscillator signal, the second local oscillator signal is a signal obtained by performing frequency offset correction on the first local oscillator signal based on the first amplitude information, the second branch comprises a second frequency-amplitude converter, and a linear working interval corresponding to the second frequency-amplitude converter is smaller than a linear working interval corresponding to the first frequency-amplitude converter.

2. The communication apparatus according to claim 1, wherein

   the communication apparatus further comprises a frequency offset estimation module and a local oscillator;
   the first frequency-amplitude converter is further configured to send the first amplitude information to the frequency offset estimation module;
   the frequency offset estimation module is configured to: obtain a first frequency offset value based on the first amplitude information, and send the first frequency offset value to the local oscillator; and
   the local oscillator is configured to perform frequency offset correction on the first local oscillator signal based on the first frequency offset value, to obtain the second local oscillator signal.

3. The communication apparatus according to claim 1 or 2, wherein the first frequency-amplitude converter comprises a first phase shifting unit, and the first phase shifting unit introduces different phase shifts to signals at different frequencies based on a first frequency-phase curve; and
   the second frequency-amplitude converter comprises a second phase shifting unit, the second phase shifting unit introduces different phase shifts to signals at different frequencies based on a second frequency-phase curve, and a slope of the second frequency-phase curve is greater than a slope of the first frequency-phase curve.

4. The communication apparatus according to any one of claims 1 to 3, wherein a differential frequency modulation scheme is used for the second signal;

   the second frequency-amplitude converter is configured to obtain third amplitude information of the fourth signal; and
   the second branch is further specifically configured to:

      obtain, based on the third amplitude information of the fourth signal, a frequency difference of the fourth signal transmitted in adjacent time units, wherein a frequency of the fourth signal transmitted in an $i$th time unit is: $f(i)$ =mod[$f(i-1)$+$\Delta f_1(i)$, B1], $\Delta f_1(i)$ is a difference between a frequency of an $i$th fourth signal and a frequency of an $(i-1)$th fourth signal in a sequence of the fourth signal, B1 is a preset first bandwidth value, and i is an integer greater than 1; and

obtain, based on the frequency difference of the fourth signal, modulation information carried in the fourth signal.

5. The communication apparatus according to any one of claims 1 to 4, wherein a differential frequency modulation scheme is used for the first signal, and the first branch is configured to:

obtain, based on the first amplitude information, a frequency difference of the third signal transmitted in adjacent time units, wherein a frequency of the third signal transmitted in a $j$th time unit is: $f(j)$=mod[$f(j-1)$+$\Delta f_1(j)$, B3], $\Delta f_1(j)$ is a difference between a frequency of a $j$th third signal and a frequency of a $(j-1)$th third signal in a sequence of the third signal, B3 is a preset third bandwidth value, and $j$ is an integer greater than 1; and

obtain, based on the frequency difference of the third signal, modulation information carried in the third signal.

6. A communication apparatus, wherein

the communication apparatus is configured to receive a second signal, wherein the second signal indicates the communication apparatus to enter a connected state; and

the communication apparatus comprises a first branch and a second branch, wherein

the first branch comprises a first frequency-amplitude converter, configured to obtain second amplitude information of a fifth signal, wherein the fifth signal is a signal obtained by performing frequency mixing on the second signal and a first local oscillator signal, and the first local oscillator signal is a local oscillator signal generated by the communication apparatus; and

the second branch is configured to demodulate a sixth signal, wherein the sixth signal is a signal obtained by performing frequency mixing on the second signal and a second local oscillator signal, the second local oscillator signal is a signal obtained by performing frequency offset correction on the first local oscillator signal based on the second amplitude information, the second branch comprises a second frequency-amplitude converter, and a linear working interval corresponding to the second frequency-amplitude converter is smaller than a linear working interval corresponding to the first frequency-amplitude converter.

7. The communication apparatus according to claim 6, wherein

the communication apparatus further comprises a frequency offset estimation module and a local oscillator; the first frequency-amplitude converter is further configured to send the second amplitude information to the frequency offset estimation module;

the frequency offset estimation module is configured to: obtain a second frequency offset value based on the second amplitude information, and send the second frequency offset value to the local oscillator; and

the local oscillator is configured to perform frequency offset correction on the first local oscillator signal based on the second frequency offset value, to obtain the second local oscillator signal.

8. The communication apparatus according to claim 6 or 7, wherein the first frequency-amplitude converter comprises a first phase shifting unit, and the first phase shifting unit introduces different phase shifts to signals at different frequencies based on a first frequency-phase curve; and

the second frequency-amplitude converter comprises a second phase shifting unit, the second phase shifting unit introduces different phase shifts to signals at different frequencies based on a second frequency-phase curve, and a slope of the second frequency-phase curve is greater than a slope of the first frequency-phase curve.

9. The communication apparatus according to any one of claims 6 to 8, wherein a differential frequency modulation scheme is used for the second signal, and the second branch is further specifically configured to:

obtain a frequency difference of a filtered sixth signal transmitted in adjacent time units, wherein a frequency of the filtered sixth signal transmitted in an $i$th time unit is: $f(i)$=mod[$f(i-1)$+$\Delta f_2(i)$, B2], $\Delta f_2(i)$ is a difference between a frequency of an $i$th sixth signal and a frequency of an $(i-1)$th sixth signal in a sequence of the filtered sixth signal, B2 is a preset second bandwidth value, and $i$ is an integer greater than 1; and

obtain, based on the frequency difference of the filtered sixth signal, modulation information carried in the filtered sixth signal.

33

10. A communication apparatus, wherein

the communication apparatus is configured to receive a first signal and a second signal, wherein both the second signal and the first signal are from a same device, and the second signal indicates the communication apparatus to enter a connected state; and

the communication apparatus comprises a first branch and a second branch, wherein

the first branch comprises a first filter, configured to filter a third signal, wherein the third signal is a signal obtained by performing frequency mixing on the first signal and a first local oscillator signal, and the first local oscillator signal is a local oscillator signal generated by the communication apparatus; and

the second branch comprises a second filter, configured to filter a fourth signal, wherein the fourth signal is a signal obtained by performing frequency mixing on the second signal and a second local oscillator signal, the second local oscillator signal is a signal obtained by performing frequency offset correction on the first local oscillator signal based on first amplitude information of the third signal, and a bandwidth of the second filter is less than a bandwidth of the first filter.

11. The communication apparatus according to claim 10, wherein

the first branch further comprises a first frequency-amplitude converter, configured to obtain the first amplitude information;

the communication apparatus further comprises a frequency offset estimation module and a local oscillator;

the first frequency-amplitude converter is further configured to send the first amplitude information to the frequency offset estimation module;

the frequency offset estimation module is configured to: obtain a first frequency offset value based on the first amplitude information, and send the first frequency offset value to the local oscillator; and

the local oscillator is configured to perform frequency offset correction on the first local oscillator signal based on the first frequency offset value, to obtain the second local oscillator signal.

12. The communication apparatus according to claim 11, wherein the second branch further comprises a second frequency-amplitude converter, configured to demodulate a filtered fourth signal, wherein a linear working interval corresponding to the second frequency-amplitude converter is smaller than a linear working interval corresponding to the first frequency-amplitude converter.

13. The communication apparatus according to claim 12, wherein the first frequency-amplitude converter comprises a first phase shifting unit, and the first phase shifting unit introduces different phase shifts to signals at different frequencies based on a first frequency-phase curve; and

the second frequency-amplitude converter comprises a second phase shifting unit, the second phase shifting unit introduces different phase shifts to signals at different frequencies based on a second frequency-phase curve, and a slope of the second frequency-phase curve is greater than a slope of the first frequency-phase curve.

14. The communication apparatus according to claim 12 or 13, wherein a differential frequency modulation scheme is used for the second signal;

the second frequency-amplitude converter is configured to obtain third amplitude information of the fourth signal; and

the second branch is further specifically configured to:

obtain, based on the third amplitude information of the fourth signal, a frequency difference of the fourth signal transmitted in adjacent time units, wherein a frequency of the fourth signal transmitted in an $i^{th}$ time unit is: $f(i) = mod[f(i-1)+\Delta f_1(i), B1]$, $\Delta f_1(i)$ is a difference between a frequency of an $i^{th}$ fourth signal and a frequency of an $(i-1)^{th}$ fourth signal in a sequence of the fourth signal, B1 is a preset first bandwidth value, and $i$ is an integer greater than 1; and

obtain, based on the frequency difference of the filtered fourth signal, modulation information carried in the filtered fourth signal.

15. The communication apparatus according to any one of claims 11 to 14, wherein a differential frequency modulation scheme is used for the first signal, and the first branch is configured to:

obtain, based on the first amplitude information, a frequency difference of the third signal transmitted in adjacent time units, wherein a frequency of the third signal transmitted in a $j$th time unit is: $f(j)=\text{mod}[f(j\text{-}1)+\Delta f_1(j), B3]$, $\Delta f_1(j)$ is a difference between a frequency of a $j$th third signal and a frequency of a $(j\text{-}1)$th third signal in a sequence of the third signal, B3 is a preset third bandwidth value, and $j$ is an integer greater than 1; and

obtain, based on the frequency difference of the third signal, modulation information carried in the third signal.

16. A communication apparatus, wherein

the communication apparatus is configured to receive a second signal, wherein the second signal indicates the communication apparatus to enter a connected state; and

the communication apparatus comprises a first branch and a second branch, wherein

the first branch comprises a first filter, configured to filter a fifth signal, wherein the fifth signal is a signal obtained by performing frequency mixing on the second signal and a first local oscillator signal, and the first local oscillator signal is a local oscillator signal generated by the communication apparatus; and

the second branch comprises a second filter, configured to filter a sixth signal, wherein the sixth signal is a signal obtained by performing frequency mixing on the second signal and a second local oscillator signal, the second local oscillator signal is a signal obtained by performing frequency offset correction on the first local oscillator signal based on second amplitude information of the fifth signal, and a bandwidth of the second filter is less than a bandwidth of the first filter.

17. The communication apparatus according to claim 16, wherein

the first branch further comprises a first frequency-amplitude converter, configured to obtain the second amplitude information;

the communication apparatus further comprises a frequency offset estimation module and a local oscillator;

the first frequency-amplitude converter is further configured to send the second amplitude information to the frequency offset estimation module;

the frequency offset estimation module is configured to: obtain a second frequency offset value based on the second amplitude information, and send the second frequency offset value to the local oscillator; and

the local oscillator is configured to perform frequency offset correction on the first local oscillator signal based on the second frequency offset value, to obtain the second local oscillator signal.

18. The communication apparatus according to claim 17, wherein the second branch further comprises a second frequency-amplitude converter, configured to demodulate a filtered sixth signal, wherein a linear working interval corresponding to the second frequency-amplitude converter is smaller than a linear working interval corresponding to the first frequency-amplitude converter.

19. The communication apparatus according to claim 18, wherein the first frequency-amplitude converter comprises a first phase shifting unit, and the first phase shifting unit introduces different phase shifts to signals at different frequencies based on a first frequency-phase curve; and

the second frequency-amplitude converter comprises a second phase shifting unit, the second phase shifting unit introduces different phase shifts to signals at different frequencies based on a second frequency-phase curve, and a slope of the second frequency-phase curve is greater than a slope of the first frequency-phase curve.

20. The communication apparatus according to claim 18 or 19, wherein a differential frequency modulation scheme is used for the second signal, and the second branch is further specifically configured to:

obtain a frequency difference of the filtered sixth signals transmitted in adjacent time units, wherein a frequency of the filtered sixth signal transmitted in an $i$th time unit is: $f(i)=\text{mod}[f(i\text{-}1)+\Delta f_2(i), B2]$, $\Delta f_2(i)$ is a difference between a frequency of an $i$th sixth signal and a frequency of an $(i\text{-}1)$th sixth signal in a sequence of the filtered sixth signal, B2 is a preset second bandwidth value, and $i$ is an integer greater than 1; and

obtain, based on the frequency difference of the filtered sixth signal, modulation information carried in the filtered sixth signal.

21. A communication method, wherein the communication method is applied to a communication apparatus, the communication apparatus comprises a first branch and a second branch, the first branch comprises a first frequency-amplitude converter, the second branch comprises a second frequency-amplitude converter, a linear working interval corresponding to the second frequency-amplitude converter is smaller than a linear working interval corresponding to the first frequency-amplitude converter, and the communication method comprises:

receiving a first signal and a second signal, wherein both the second signal and the first signal are from a same device, and the second signal indicates the communication apparatus to enter a connected state;

obtaining first amplitude information of a third signal by using the first frequency-amplitude converter, wherein the third signal is a signal obtained by performing frequency mixing on the first signal and a first local oscillator signal, and the first local oscillator signal is a local oscillator signal generated by the communication apparatus; and demodulating a fourth signal through the second branch, wherein the fourth signal is a signal obtained by performing frequency mixing on the second signal and a second local oscillator signal, and the second local oscillator signal is a signal obtained by performing frequency offset correction on the first local oscillator signal based on the first amplitude information.

22. The communication method according to claim 21, wherein before the demodulating a fourth signal through the second branch, the communication method further comprises:

obtaining a first frequency offset value based on the first amplitude information; and performing frequency offset correction on the first local oscillator signal based on the first frequency offset value, to obtain the second local oscillator signal.

23. The communication method according to claim 21 or 22, wherein the first frequency-amplitude converter comprises a first phase shifting unit, and the first phase shifting unit introduces different phase shifts to signals at different frequencies based on a first frequency-phase curve; and the second frequency-amplitude converter comprises a second phase shifting unit, the second phase shifting unit introduces different phase shifts to signals at different frequencies based on a second frequency-phase curve, and a slope of the second frequency-phase curve is greater than a slope of the first frequency-phase curve.

24. The communication method according to any one of claims 21 to 23, wherein a differential frequency modulation scheme is used for the second signal;

the communication method further comprises:
obtaining third amplitude information of the fourth signal by using the second frequency-amplitude converter; and the demodulating a fourth signal through the second branch comprises:

obtaining, through the second branch, a frequency difference of the fourth signal transmitted in adjacent time units, wherein a frequency of the fourth signal transmitted in an $i^{th}$ time unit is: $f(i)=\mathrm{mod}[f(i\text{-}1)+\Delta f_1(i), \mathrm{B1}]$, $\Delta f_1(i)$ is a difference between a frequency of an $i^{th}$ fourth signal and a frequency of an $(i\text{-}1)^{th}$ fourth signal in a sequence of the fourth signal, B 1 is a preset first bandwidth value, and $i$ is an integer greater than 1; and obtaining, based on the frequency difference of the fourth signal, modulation information carried in the fourth signal.

25. The communication method according to any one of claims 21 to 24, wherein a differential frequency modulation scheme is used for the first signal, and the method further comprises:

obtaining, through the first branch based on the first amplitude information, a frequency difference of the third signal transmitted in adjacent time units, wherein a frequency of the third signal transmitted in a $j^{th}$ time unit is: $f(j)=\mathrm{mod}[f(j\text{-}1)+\Delta f_1(j), \mathrm{B3}]$, $\Delta f_1(j)$ is a difference between a frequency of a $j^{th}$ third signal and a frequency of a $(j\text{-}1)^{th}$ third signal in a sequence of the third signal, B3 is a preset third bandwidth value, and $j$ is an integer greater than 1; and obtaining, based on the frequency difference of the third signal, modulation information carried in the third signal.

26. A communication method, wherein the communication method is applied to a communication apparatus, the communication apparatus comprises a first branch and a second branch, the first branch comprises a first frequency-amplitude converter, the second branch comprises a second frequency-amplitude converter, a linear working interval corresponding to the second frequency-amplitude converter is smaller than a linear working interval corresponding to the first frequency-amplitude converter, and the communication method comprises:

receiving a second signal, wherein the second signal indicates the communication apparatus to enter a connected state;
obtaining second amplitude information of a fifth signal by using the first frequency-amplitude converter, wherein the fifth signal is a signal obtained by performing frequency mixing on the second signal and a first local oscillator signal, and the first local oscillator signal is a local oscillator signal generated by the communication apparatus; and

demodulating a sixth signal through the second branch, wherein the sixth signal is a signal obtained by performing frequency mixing on the second signal and a second local oscillator signal, and the second local oscillator signal is a signal obtained by performing frequency offset correction on the first local oscillator signal based on the second amplitude information.

27. The communication method according to claim 26, wherein before the demodulating a sixth signal through the second branch, the communication method further comprises:

obtaining a second frequency offset value based on the second amplitude information; and
performing frequency offset correction on the first local oscillator signal based on the second frequency offset value, to obtain the second local oscillator signal.

28. The communication method according to claim 26 or 27, wherein the first frequency-amplitude converter comprises a first phase shifting unit, and the first phase shifting unit introduces different phase shifts to signals at different frequencies based on a first frequency-phase curve; and
the second frequency-amplitude converter comprises a second phase shifting unit, the second phase shifting unit introduces different phase shifts to signals at different frequencies based on a second frequency-phase curve, and a slope of the second frequency-phase curve is greater than a slope of the first frequency-phase curve.

29. The communication method according to any one of claims 26 to 28, wherein a differential frequency modulation scheme is used for the second signal, and the demodulating a sixth signal through the second branch comprises:

obtaining, through the second branch, a frequency difference of a filtered sixth signal transmitted in adjacent time units, wherein a frequency of the filtered sixth signal transmitted in an $i^{th}$ time unit is: $f(i)=\text{mod}[f(i-1)+\Delta f_2(i), B2]$, $\Delta f_2(i)$ is a difference between a frequency of an $i^{th}$ sixth signal and a frequency of an $(i-1)^{th}$ sixth signal in a sequence of the filtered sixth signal, B2 is a preset second bandwidth value, and $i$ is an integer greater than 1; and
obtaining, based on the frequency difference of the filtered sixth signal, modulation information carried in the filtered sixth signal.

30. A communication method, wherein the communication method is applied to a communication apparatus, the communication apparatus comprises a first branch and a second branch, the first branch comprises a first filter, the second branch comprises a second filter, a bandwidth of the second filter is less than a bandwidth of the first filter, and the communication method comprises:

receiving a first signal and a second signal, wherein both the second signal and the first signal are from a same device, and the second signal indicates the communication apparatus to enter a connected state;
filtering a third signal by using the first filter, wherein the third signal is a signal obtained by performing frequency mixing on the first signal and a first local oscillator signal, and the first local oscillator signal is a local oscillator signal generated by the communication apparatus; and
filtering a fourth signal by using the second filter, wherein the fourth signal is a signal obtained by performing frequency mixing on the second signal and a second local oscillator signal, and the second local oscillator signal is a signal obtained by performing frequency offset correction on the first local oscillator signal based on first amplitude information of the third signal.

31. The communication method according to claim 30, wherein the first branch further comprises a first frequency-amplitude converter, and before the filtering a fourth signal by using the second filter, the communication method further comprises:

obtaining the first amplitude information by using the first frequency-amplitude converter;
obtaining a first frequency offset value based on the first amplitude information; and
performing frequency offset correction on the first local oscillator signal based on the first frequency offset value, to obtain the second local oscillator signal.

32. The communication method according to claim 31, wherein the second branch further comprises a second frequency-amplitude converter, a linear working interval corresponding to the second frequency-amplitude converter is smaller than a linear working interval corresponding to the first frequency-amplitude converter, and the communication method further comprises:

> obtaining third amplitude information of the fourth signal by using the second frequency-amplitude converter; and demodulating a filtered fourth signal based on the third amplitude information of the fourth signal.

33. The communication method according to claim 32, wherein the first frequency-amplitude converter comprises a first phase shifting unit, and the first phase shifting unit introduces different phase shifts to signals at different frequencies based on a first frequency-phase curve; and
the second frequency-amplitude converter comprises a second phase shifting unit, the second phase shifting unit introduces different phase shifts to signals at different frequencies based on a second frequency-phase curve, and a slope of the second frequency-phase curve is greater than a slope of the first frequency-phase curve.

34. The communication method according to claim 32 or 33, wherein a differential frequency modulation scheme is used for the second signal, and the demodulating a filtered fourth signal based on the third amplitude information of the fourth signal comprises:

> obtaining, through the second branch based on the third amplitude information of the fourth signal, a frequency difference of the fourth signal transmitted in adjacent time units, wherein a frequency of the fourth signal transmitted in an $i^{th}$ time unit is: $f(i)=\text{mod}[f(i\text{-}1)+\Delta f_1(i), B1]$, $\Delta f_1(i)$ is a difference between a frequency of an $i^{th}$ fourth signal and a frequency of an $(i\text{-}1)^{th}$ fourth signal in a sequence of the fourth signal, B1 is a preset first bandwidth value, and i is an integer greater than 1; and
> obtaining, based on the frequency difference of the filtered fourth signal, modulation information carried in the filtered fourth signal.

35. The communication method according to any one of claims 31 to 34, wherein a differential frequency modulation scheme is used for the first signal, and the method further comprises:

> obtaining, through the first branch based on the first amplitude information, a frequency difference of the third signal transmitted in adjacent time units, wherein a frequency of the third signal transmitted in a $j^{th}$ time unit is: $f(j)=\text{mod}[f(j\text{-}1)+\Delta f_1(j), B3]$, $\Delta f_1(j)$ is a difference between a frequency of a $j^{th}$ third signal and a frequency of a $(j\text{-}1)^{th}$ third signal in a sequence of the third signal, B3 is a preset third bandwidth value, and j is an integer greater than 1; and
> obtaining, based on the frequency difference of the third signal, modulation information carried in the third signal.

36. A communication method, wherein the communication method is applied to a communication apparatus, the communication apparatus comprises a first branch and a second branch, the first branch comprises a first filter, the second branch comprises a second filter, a bandwidth of the second filter is less than a bandwidth of the first filter, and the communication method comprises:

> receiving a second signal, wherein the second signal indicates the communication apparatus to enter a connected state;
> filtering a fifth signal by using the first filter, wherein the fifth signal is a signal obtained by performing frequency mixing on the second signal and a first local oscillator signal, and the first local oscillator signal is a local oscillator signal generated by the communication apparatus; and
> filtering a sixth signal by using the second filter, wherein the sixth signal is a signal obtained by performing frequency mixing on the second signal and a second local oscillator signal, and the second local oscillator signal is a signal obtained by performing frequency offset correction on the first local oscillator signal based on second amplitude information of the fifth signal.

37. The communication method according to claim 36, wherein the first branch further comprises a first frequency-amplitude converter, and before the filtering a sixth signal by using the second filter, the communication method further comprises:

> obtaining the second amplitude information by using the first frequency-amplitude converter;
> obtaining a second frequency offset value based on the second amplitude information; and
> performing frequency offset correction on the first local oscillator signal based on the second frequency offset value, to obtain the second local oscillator signal.

38. The communication method according to claim 37, wherein the second branch further comprises a second frequency-amplitude converter, a linear working interval corresponding to the second frequency-amplitude converter is smaller than a linear working interval corresponding to the first frequency-amplitude converter, and the communication method further comprises:
demodulating a filtered sixth signal.

39. The communication method according to claim 38, wherein the first frequency-amplitude converter comprises a first phase shifting unit, and the first phase shifting unit introduces different phase shifts to signals at different frequencies based on a first frequency-phase curve; and
the second frequency-amplitude converter comprises a second phase shifting unit, the second phase shifting unit introduces different phase shifts to signals at different frequencies based on a second frequency-phase curve, and a slope of the second frequency-phase curve is greater than a slope of the first frequency-phase curve.

40. The communication method according to claim 38 or 39, wherein a differential frequency modulation scheme is used for the second signal, and the demodulating a filtered sixth signal comprises:

   obtaining a frequency difference of the filtered sixth signal transmitted in adjacent time units, wherein a frequency of the filtered sixth signal transmitted in an $i^{th}$ time unit is: $f(i)=\mathrm{mod}[f(i-1)+\Delta f_2(i), B2]$, $\Delta f_2(i)$ is a difference between a frequency of an $i^{th}$ sixth signal and a frequency of an $(i-1)^{th}$ sixth signal in a sequence of the filtered sixth signal, B2 is a preset second bandwidth value, and $i$ is an integer greater than 1; and
   obtaining, based on the frequency difference of the filtered sixth signal, modulation information carried in the filtered sixth signal.

41. A communication apparatus, comprising:

   one or more processors;
   one or more memories; and
   one or more computer programs, wherein the one or more computer programs are stored in the one or more memories, the one or more computer programs comprise instructions, and when the instructions are executed by the one or more processors, the communication apparatus is enabled to perform the communication method according to any one of claims 21 to 40.

42. A computer-readable storage medium, comprising computer instructions, wherein when the computer instructions are run on a communication apparatus, the communication apparatus is enabled to perform the communication method according to any one of claims 21 to 40.

43. A chip, comprising at least one processor and an interface circuit, wherein the interface circuit is configured to provide program instructions or data for the at least one processor, and the at least one processor is configured to execute the program instructions, to implement the communication method according to any one of claims 21 to 40.

FIG. 1

FIG. 2

FIG. 3

RF BPF → RF LNA → ⊗ (LO) → IF LNA → BPF → FM-AM → LPF → Envelope or amplitude detection module

FIG. 4

FIG. 5

FIG. 6

FIG. 7

FIG. 8

FIG. 9

FIG. 10

Communication apparatus 800

Local oscillator
830

First frequency offset value

First local
oscillator
signal

Second
local
oscillator
signal

First signal

Second signal

Third signal

First branch 810

First frequency-amplitude
converter 811

First
amplitude
information

Frequency offset
estimation module 812

Fourth signal

Second branch 820

Second frequency-amplitude
converter 821

FIG. 11

FIG. 12

Communication apparatus 1400

Frequency-amplitude
converter 1410

FIG. 13

Frequency-amplitude converter 1410

1413

$S(t)$ → → $S(t)Sp(t)$

First capacitor
1411

$Sp(t)$

RLC resonator
1412

FIG. 14

RLC resonator 1412

| Inductor 14122 | Second capacitor 14121 | Variable resistor 14123 |

FIG. 15

Communication apparatus 1400

Control signal

Fifth signal → Frequency-amplitude converter 1410 → Second amplitude information → Frequency offset estimation module 1420

FIG. 16

FIG. 17

FIG. 18

FIG. 19

Communication apparatus 900

FIG. 20

Communication apparatus 900

First frequency offset value

Frequency offset estimation module 913

First amplitude information

First frequency-amplitude converter 912

Second frequency-amplitude converter 922

Third signal

Fourth signal

First filter 911

Second filter 921

Third signal

First branch 910

Fourth signal

Second branch 920

Local oscillator 930

Second local oscillator signal

First local oscillator signal

First signal

Second signal

FIG. 21

Communication apparatus 1500

Filter 1510

FIG. 22

Communication apparatus 1500

Filter 1510 — Fifth signal → Frequency-amplitude converter 1410 — Second amplitude information →

FIG. 23

Communication apparatus 1500

Control signal

Filter 1510 — Fifth signal → Frequency-amplitude converter 1410 — Second amplitude information → Frequency offset estimation module 1420

FIG. 24

EP 4 507 255 A1

FIG. 25

Communication apparatus 1500

Local oscillator 1430

Second frequency offset value

First local oscillator signal

Second local oscillator signal

Fifth signal

Second signal

Filter 1510

Fifth signal

Control signal

Frequency-amplitude converter 1410

Second amplitude information

Fourth amplitude information

Frequency offset estimation module 1420

Envelope or amplitude detection module 1440

FIG. 26

1000

| First device | | Second device |

S1010: First signal →

S1020: Second signal →

S1030: Obtain first amplitude information of a third signal by using a first frequency-amplitude converter, where the third signal is a signal obtained by performing frequency mixing on the first signal and a first local oscillator signal

S1040: Demodulate a fourth signal through a second branch, where the fourth signal is a signal obtained by performing frequency mixing on the second signal and a second local oscillator signal, and the second local oscillator signal is a signal obtained by performing frequency offset correction on the first local oscillator signal based on the first amplitude information

FIG. 27

1100

```
┌─────────────────────┐                         ┌─────────────────────┐
│     First device    │                         │    Second device    │
└─────────────────────┘                         └─────────────────────┘
          │                                                 │
          ├──────────── S1110: Second signal ──────────────▶│
          │                                                 │
          │              ┌──────────────────────────────────────────┐
          │              │   S1120: Obtain second amplitude          │
          │              │ information of a fifth signal by using a  │
          │              │   first frequency-amplitude converter,    │
          │              │  where the fifth signal is a signal       │
          │              │  obtained by performing frequency mixing  │
          │              │  on the second signal and a first local   │
          │              │           oscillator signal               │
          │              └──────────────────────────────────────────┘
          │              ┌──────────────────────────────────────────┐
          │              │ S1130: Demodulate a sixth signal through a│
          │              │  second branch, where the sixth signal is │
          │              │  a signal obtained by performing frequency│
          │              │  mixing on the second signal and a second │
          │              │ local oscillator signal, and the second   │
          │              │ local oscillator signal is a signal       │
          │              │ obtained by performing frequency offset   │
          │              │ correction on the first local oscillator  │
          │              │ signal based on the second amplitude      │
          │              │            information                     │
          │              └──────────────────────────────────────────┘
```

FIG. 28

1600

```
┌─────────────────┐                              ┌─────────────────┐
│   First device  │                              │  Second device  │
└─────────────────┘                              └─────────────────┘
         │                                                │
         │──────── S1610: Second signal ─────────────────▶│
         │                                                │
```

S1620: A frequency-amplitude converter obtains second amplitude information of a fifth signal in a first linear working interval, where the fifth signal is a signal obtained by performing frequency mixing on the second signal and a first local oscillator signal

S1630: The frequency-amplitude converter demodulates a sixth signal in a second linear working interval, where the sixth signal is a signal obtained by performing frequency mixing on the second signal and a second local oscillator signal, the second local oscillator signal is a signal obtained by performing frequency offset correction on the first local oscillator signal based on the second amplitude information, and the second linear working interval is smaller than the first linear working interval

FIG. 29

1200

```
┌─────────────────────┐                              ┌─────────────────────┐
│    First device     │                              │    Second device    │
└─────────────────────┘                              └─────────────────────┘
           │                                                     │
           │────────── S1210: First signal ─────────────────────▶│
           │                                                     │
           │────────── S1220: Second signal ────────────────────▶│
           │                                                     │
```

S1230: Filter a third signal by using a first filter, where the third signal is a signal obtained by performing frequency mixing on the first signal and a first local oscillator signal

S1240: Filter a fourth signal by using a second filter, where the fourth signal is a signal obtained by performing frequency mixing on the second signal and a second local oscillator signal, and the second local oscillator signal is a signal obtained by performing frequency offset correction on the first local oscillator signal based on first amplitude information of the third signal

FIG. 30

1300

```
┌─────────────────────┐                              ┌─────────────────────┐
│    First device     │                              │    Second device    │
└─────────────────────┘                              └─────────────────────┘
           │                                                     │
           │────────── S1310: Second signal ────────────────────▶│
           │                                                     │
```

S1320: Filter a fifth signal by using a first filter, where the fifth signal is a signal obtained by performing frequency mixing on the second signal and a first local oscillator signal

S1330: Filter a sixth signal by using a second filter, where the sixth signal is a signal obtained by performing frequency mixing on the second signal and a second local oscillator signal, and the second local oscillator signal is a signal obtained by performing frequency offset correction on the first local oscillator signal based on second amplitude information of the fifth signal

FIG. 31

1700

First device

Second device

S1710: Second signal

S1720: A filter filters a fifth signal based on a first bandwidth, where the fifth signal is a signal obtained by performing frequency mixing on the second signal and a first local oscillator signal

S1730: The filter filters a sixth signal based on a second bandwidth, where the sixth signal is a signal obtained by performing frequency mixing on the second signal and a second local oscillator signal, the second local oscillator signal is a signal obtained by performing frequency offset correction on the first local oscillator signal based on second amplitude information of the fifth signal, and the second bandwidth is less than the first bandwidth

FIG. 32

<div align="center">**INTERNATIONAL SEARCH REPORT**</div>

| International application No. |
| --- |
| **PCT/CN2023/090781** |

**A.    CLASSIFICATION OF SUBJECT MATTER**

H04L27/144(2006.01)i

According to International Patent Classification (IPC) or to both national classification and IPC

**B.    FIELDS SEARCHED**

Minimum documentation searched (classification system followed by classification symbols)

IPC:H04W,H04L,H04Q

Documentation searched other than minimum documentation to the extent that such documents are included in the fields searched

Electronic data base consulted during the international search (name of data base and, where practicable, search terms used)

CNTXT, ENTXT, DWPI, CNKI: 本振, 本地振荡, 频偏, 频率偏移, 纠正, 估计, 混频, 解调, 滤波器, FM-AM转换器, 频率幅值转换, local oscillator, LO, frequency, offset, correction, mixing, demodulation, filter

**C.    DOCUMENTS CONSIDERED TO BE RELEVANT**

| Category* | Citation of document, with indication, where appropriate, of the relevant passages | Relevant to claim No. |
| --- | --- | --- |
| A | CN 1493113 A (INTERWAVE COMMUNICATION INC.) 28 April 2004 (2004-04-28) description, p. 2, paragraph 31 to p. 6, paragraph 2 | 1-43 |
| A | CN 102307071 A (SHIJIAZHUANG DEVELOPMENT ZONE TAISHUN ELECTRONIC COMMUNICATION CO., LTD.) 04 January 2012 (2012-01-04) entire document | 1-43 |
| A | CN 108092929 A (BEIJING INSTITUTE OF TECHNOLOGY) 29 May 2018 (2018-05-29) entire document | 1-43 |
| A | CN 108183876 A (BEIJING AEROSPACE MEASUREMENT & CONTROL TECHNOLOGY CO., LTD.) 19 June 2018 (2018-06-19) entire document | 1-43 |
| A | US 2017134198 A1 (KABUSHIKI KAISHA TOSHIBA) 11 May 2017 (2017-05-11) entire document | 1-43 |

☐ Further documents are listed in the continuation of Box C.          ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **18 July 2023** | **26 July 2023** |

| Name and mailing address of the ISA/CN | Authorized officer |
| --- | --- |
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/090781**

| Patent document cited in search report | | | Publication date (day/month/year) | Patent family member(s) | | | Publication date (day/month/year) |
|---|---|---|---|---|---|---|---|
| CN | 1493113 | A | 28 April 2004 | WO | 0219546 | A2 | 07 March 2002 |
| | | | | US | 6675004 | B1 | 06 January 2004 |
| | | | | AU | 8664101 | A | 13 March 2002 |
| CN | 102307071 | A | 04 January 2012 | None | | | |
| CN | 108092929 | A | 29 May 2018 | None | | | |
| CN | 108183876 | A | 19 June 2018 | None | | | |
| US | 2017134198 | A1 | 11 May 2017 | WO | 2016021466 | A1 | 11 February 2016 |
| | | | | JP | 2016039503 | A | 22 March 2016 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210474157

- CN 202210800941